# EUROPEAN PATENT APPLICATION

(11) **EP 4 576 982 A1**
(43) Date of publication of application: **25.06.2025**
(21) Application number: 24805089.0
(22) Date of filing: 11.07.2024
(51) Int. Cl.: H10B 80/00

(54) **MEMORY CHIP, LOGIC CHIP, CHIP STACKING STRUCTURE, AND MEMORY**

(30) Priority: 17.10.2023 CN 202311349143
(71) Applicant: CXMT Corporation, Hefei, Anhui 230601 (CN)
(72) Inventor: ZHANG, Jiarui, Hefei, Anhui 230601 (CN)
(74) Representative: Gulde & Partner
(86) International application number: PCT/CN2024/104974
(87) International publication number: WO 2025/081922

(57) **Abstract**

The present disclosure provides a memory chip, a logic chip, a chip stacked structure, and a memory. The memory chip includes m channels, and the m channels are arranged in a first direction in sequence and are symmetrical about a chip axis. Each channel has a channel signal region, and each channel signal region is divided into 2×2 via regions distributed in an array. Areas of m channel signal regions are the same, and distribution positions of conductive via groups in the m channel signal regions are the same. The chip stacked structure formed based on the memory chip provided by the present disclosure implements a signal rotation transmission effect through a direct connection configuration of vias, thereby reducing parasitic capacitance on a signal transmission path and reducing parasitic resistance.

## Description

### CROSS-REFERENCE TO RELATED APPLICATIONS

This application claims priority to Chinese Patent Application No. 202311349143.9, filed with the China National Intellectual Property Administration on October 17, 2023 and entitled "MEMORY CHIP, LOGIC CHIP, CHIP STACKED STRUCTURE, AND MEMORY", which is incorporated herein by reference in its entirety.

### TECHNICAL FIELD

The present disclosure relates to the field of semiconductors, and in particular, to a memory chip, a logic chip, a chip stacked structure, and a memory.

### BACKGROUND

With the development of integrated circuit technologies, significant progress has been made in manufacturing processes of semiconductor devices. However, in recent years, the development of two-dimensional semiconductor technologies has encountered various challenges such as a physical limit, an existing developing technology limit, and a storage electron density limit. In this context, to address the difficulties encountered by two-dimensional semiconductor devices and pursue lower manufacturing costs per memory cell, a bonding process (e.g., hybrid bonding, bump bonding, or wire bonding) may be used to stack multiple chips to form a three-dimensional semiconductor device. However, for the three-dimensional semiconductor device, a connection structure between different chips still has problems such as high parasitic capacitance and high parasitic resistance, affecting signal transmission quality.

### SUMMARY

The present disclosure provides a memory chip, a logic chip, a chip stacked structure, and a memory.

The technical solutions of the present disclosure are implemented as follows:

According to a first aspect, an embodiment of the present disclosure provides a memory chip. The memory chip includes m channels, the m channels are sequentially arranged in a first direction, the memory chip has a chip axis extending in a second direction and passing through a center of the memory chip, and the m channels are symmetrical about the chip axis. Each of the channels includes a first memory array region, a channel signal region, and a second memory array region that are sequentially distributed in the second direction, a center of each channel signal region coincides with a center of the channel to which the channel signal region belongs, and m is a positive integer. The first direction is perpendicular to the second direction. Each channel signal region has a first axis and a second axis, the first axis extends in the first direction or the second direction, and the second axis and the first axis are perpendicular to each other and intersect at the center of the channel signal region to which the first axis and the second axis belong. Each channel signal region is divided into 2×2 via regions distributed in an array, a first via region and a second via region are symmetrical along the first axis of the channel signal region to which the first via region and the second via region belong, a third via region and a fourth via region are symmetrical along the first axis of the channel signal region to which the third via region and the fourth via region belong, and the first via region and the fourth via region are symmetrical along the second axis of the channel signal region to which the first via region and the fourth via region belong. Each of the via regions includes n conductive via groups, the n conductive via groups penetrate through a substrate of the memory chip in a direction perpendicular to an active surface of the memory chip, and n is a natural number. Areas of m channel signal regions are the same, and distribution positions of the conductive via groups in the m channel signal regions are the same. In the same channel signal region, n conductive via groups in the first via region and n conductive via groups in the second via region are symmetrical about the first axis of the channel signal region to which the conductive via groups belong, n conductive via groups in the third via region and n conductive via groups in the fourth via region are symmetrical about the first axis of the channel signal region to which the conductive via groups belong, and the n conductive via groups in the first via region and the n conductive via groups in the fourth via region are symmetrical about the second axis of the channel signal region to which the conductive via groups belong.

In some embodiments, each of the conductive via groups has a third axis and a fourth axis, the third axis is parallel to the first axis, and the fourth axis and the third axis are perpendicular to each other and intersect at a center of the conductive via group to which the third axis and the fourth axis belong. When each of the conductive via groups includes a first conductive via, a second conductive via, a third conductive via, and a fourth conductive via that are distributed in a 2×2 array, the first conductive via and the second conductive via are symmetrical about the third axis of the conductive via group to which the first conductive via and the second conductive via belong, the third conductive via and the fourth conductive via are symmetrical about the third axis of the conductive via group to which the third conductive via and the fourth conductive via belong, and the first conductive via and the fourth conductive via are symmetrical about the fourth axis of the conductive via group to which the first conductive via and the fourth conductive via belong. In each channel signal region, n first conductive vias in the first via region and n second conductive vias in the second via region are symmetrical about the first axis of the channel signal region to which the n first conductive vias and the n second conductive vias belong, n third conductive vias in the third via region and n fourth conductive vias in the fourth via region are symmetrical about the first axis of the channel signal region to which the n third conductive vias and the n fourth conductive vias belong, and the n first conductive vias in the first via region and the n fourth conductive vias in the fourth via region are symmetrical about the second axis of the channel signal region to which the n first conductive vias and the n fourth conductive vias belong; n second conductive vias in the first via region and n first conductive vias in the second via region are symmetrical about the first axis of the channel signal region to which the n second conductive vias and the n first conductive vias belong, n fourth conductive vias in the third via region and n third conductive vias in the fourth via region are symmetrical about the first axis of the channel signal region to which the n fourth conductive vias and the n third conductive vias belong, and the n second conductive vias in the first via region and the n third conductive vias in the fourth via region are symmetrical about the second axis of the channel signal region to which the n second conductive vias and the n third conductive vias belong; n third conductive vias in the first via region and n fourth conductive vias in the second via region are symmetrical about the first axis of the channel signal region to which the n third conductive vias and the n fourth conductive vias belong, n first conductive vias in the third via region and n second conductive vias in the fourth via region are symmetrical about the first axis of the channel signal region to which the n first conductive vias and the n second conductive vias belong, and the n third conductive vias in the first via region and the n second conductive vias in the fourth via region are symmetrical about the second axis of the channel signal region to which the n third conductive vias and the n second conductive vias belong; and n fourth conductive vias in the first via region and n third conductive vias in the second via region are symmetrical about the first axis of the channel signal region to which the n fourth conductive vias and the n third conductive vias belong, n second conductive vias in the third via region and n first conductive vias in the fourth via region are symmetrical about the first axis of the channel signal region to which the n second conductive vias and the n first conductive vias belong, and the n fourth conductive vias in the first via region and the n first conductive vias in the fourth via region are symmetrical about the second axis of the channel signal region to which the n fourth conductive vias and the n first conductive vias belong.

In some embodiments, the memory chip further includes (4×m×n) first driver circuits, the (4×m×n) first driver circuits are coupled to (4×m×n) first conductive vias in a one-to-one correspondence, and the first driver circuits are coupled to parts that are of the first conductive vias and that are located on the active surface. The first driver circuits are configured to send signals transmitted by the correspondingly connected first conductive vias to an internal circuit of the memory chip, or send signals generated by an internal circuit of the memory chip to the correspondingly connected first conductive vias.

In some embodiments, a coordinate position of each conductive via is determined based on a center of a channel signal region to which the conductive via belongs, and types of signals transmitted by four conductive vias with the same coordinate position are the same.

In some embodiments, the conductive vias are manufactured through any one or more of a via-first process (via-first), a via-middle process (via-middle), a via-last process (via-last), and a back side via-last process (back side via-last); and different conductive vias in the same memory chip are electrically isolated.

According to a second aspect, an embodiment of the present disclosure provides a logic chip. The logic chip includes m channel signal regions, the m channel signal regions are sequentially arranged in a first direction, the logic chip has a chip axis extending in a second direction and passing through a center of the logic chip, and the m channel signal regions are symmetrical about the chip axis, where m is a positive integer. Each of the channel signal regions has a first axis and a second axis, the first axis extends in the first direction or the second direction, and the second axis and the first axis are perpendicular to each other and intersect at a center of the channel signal region to which the first axis and the second axis belong. Each of the channel signal regions is divided into 2×2 via regions distributed in an array, a first via region and a second via region are symmetrical along the first axis of the channel signal region to which the first via region and the second via region belong, a third via region and a fourth via region are symmetrical along the first axis of the channel signal region to which the third via region and the fourth via region belong, and the first via region and the fourth via region are symmetrical along the second axis of the channel signal region to which the first via region and the fourth via region belong. The second direction is perpendicular to the first direction. Each of the via regions includes n conductive via groups, the n conductive via groups penetrate through a substrate of the logic chip in a direction perpendicular to an active surface of the logic chip, where n is a natural number. Areas of the m channel signal regions are the same, and distribution positions of the conductive via groups in the m channel signal regions are the same. In a same channel signal region, n conductive via groups in the first via region and n conductive via groups in the second via region are symmetrical about the first axis of the channel signal region to which the conductive via groups belong, n conductive via groups in the third via region and n conductive via groups in the fourth via region are symmetrical about the first axis of the channel signal region to which the conductive via groups belong, and the n conductive via groups in the first via region and the n conductive via groups in the fourth via region are symmetrical about the second axis of the channel signal region to which the conductive via groups belong.

In some embodiments, each of the conductive via groups has a third axis and a fourth axis, the third axis is parallel to the first axis, and the fourth axis and the third axis are perpendicular to each other and intersect at a center of the conductive via group to which the third axis and the fourth axis belong. When each of the conductive via groups includes a first conductive via, a second conductive via, a third conductive via, and a fourth conductive via that are distributed in a 2×2 array, the first conductive via and the second conductive via are symmetrical about the third axis of the conductive via group to which the first conductive via and the second conductive via belong, the third conductive via and the fourth conductive via are symmetrical about the third axis of the conductive via group to which the third conductive via and the fourth conductive via belong, and the first conductive via and the fourth conductive via are symmetrical about the fourth axis of the conductive via group to which the first conductive via and the fourth conductive via belong. In each channel signal region, n first conductive vias in the first via region and n second conductive vias in the second via region are symmetrical about the first axis of the channel signal region to which the n first conductive vias and the n second conductive vias belong, n third conductive vias in the third via region and n fourth conductive vias in the fourth via region are symmetrical about the first axis of the channel signal region to which the n third conductive vias and the n fourth conductive vias belong, and the n first conductive vias in the first via region and the n fourth conductive vias in the fourth via region are symmetrical about the second axis of the channel signal region to which the n first conductive vias and the n fourth conductive vias belong; n second conductive vias in the first via region and n first conductive vias in the second via region are symmetrical about the first axis of the channel signal region to which the n second conductive vias and the n first conductive vias belong, n fourth conductive vias in the third via region and n third conductive vias in the fourth via region are symmetrical about the first axis of the channel signal region to which the n fourth conductive vias and the n third conductive vias belong, and the n second conductive vias in the first via region and the n third conductive vias in the fourth via region are symmetrical about the second axis of the channel signal region to which the n second conductive vias and the n third conductive vias belong; n third conductive vias in the first via region and n fourth conductive vias in the second via region are symmetrical about the first axis of the channel signal region to which the n third conductive vias and the n fourth conductive vias belong, n first conductive vias in the third via region and n second conductive vias in the fourth via region are symmetrical about the first axis of the channel signal region to which the n first conductive vias and the n second conductive vias belong, and the n third conductive vias in the first via region and the n second conductive vias in the fourth via region are symmetrical about the second axis of the channel signal region to which the n third conductive vias and the n second conductive vias belong; and n fourth conductive vias in the first via region and n third conductive vias in the second via region are symmetrical about the first axis of the channel signal region to which the n fourth conductive vias and the n third conductive vias belong, n second conductive vias in the third via region and n first conductive vias in the fourth via region are symmetrical about the first axis of the channel signal region to which the n second conductive vias and the n first conductive vias belong, and the n fourth conductive vias in the first via region and the n first conductive vias in the fourth via region are symmetrical about the second axis of the channel signal region to which the n fourth conductive vias and the n first conductive vias belong.

In some embodiments, the logic chip further includes (16×m×n) second driver circuits, the (16×m×n) second driver circuits are coupled to (16×m×n) conductive vias in a one-to-one correspondence, and the second driver circuits are coupled to parts that are of the conductive vias and that are located on the active surface. The second driver circuits are configured to send signals transmitted by the corresponding conductive vias to an internal circuit of the logic chip, or send signals generated by an internal circuit of the logic chip to the corresponding conductive vias.

In some embodiments, a coordinate position of each conductive via is determined based on a center of a channel signal region to which the conductive via belongs, and types of signals transmitted by four conductive vias with the same coordinate position are the same. The conductive vias are manufactured through any one or more of a via-first process (via-first), a via-middle process (via-middle), a via-last process (via-last), and a back side via-last process (back side via-last); and different conductive vias in the same logic chip are electrically isolated from each other.

According to a third aspect, an embodiment of the present disclosure provides a chip stacked structure. The chip stacked structure includes the logic chip described in the second aspect and at least one stacked unit. The logic chip and the at least one stacked unit are sequentially stacked in a third direction. Each stacked unit includes a first memory chip, a second memory chip, a third memory chip and a fourth memory chip that are sequentially stacked in the third direction. The third direction is perpendicular to an active surface of each of the memory chips. The first memory chip, the second memory chip, the third memory chip, and the fourth memory chip each are the memory chip described in the first aspect.

The logic chip and the first memory chip are stacked in a face-to-back or back-to-back manner.

The first memory chip and the second memory chip are stacked in a face-to-face manner.

The second memory chip and the third memory chip are stacked in a back-to-back manner.

The third memory chip and the fourth memory chip are stacked in a face-to-face manner.

In some embodiments, the logic chip includes m channel signal regions arranged in a first direction, each of the memory chips has m channels arranged in the first direction, and each of the channels includes a first memory array region, a channel signal region, and a second memory array region that are sequentially distributed in a second direction. When the logic chip and the first memory chip are stacked in a back-to-back manner, and a first axis of the logic chip and a first axis of each of the memory chips extend in the first direction, the (m-i)th channel signal region in the logic chip is aligned with the channel signal region in the (i+1)th channel in the first memory chip, the channel signal region in the (i+1)th channel in the second memory chip, the channel signal region in the (m-i)th channel in the third memory chip, and the channel signal region in the (m-i)th channel in the fourth memory chip in the third direction, where i is a natural number less than m.

In some embodiments, the logic chip includes m channel signal regions arranged in a first direction, each of the memory chips has m channels arranged in the first direction, and each of the channels includes a first memory array region, a channel signal region, and a second memory array region that are sequentially distributed in a second direction. When the logic chip and the first memory chip are stacked in a back-to-back manner, and a second axis of the logic chip and a second axis of each of the memory chips extend in the first direction, the (i+1)th channel signal region in the logic chip is aligned with the channel signal region in the (i+1)th channel in the first memory chip, the channel signal region in the (m-i)th channel in the second memory chip, the channel signal region in the (m-i)th channel in the third memory chip, and the channel signal region in the (i+1)th channel in the fourth memory chip in the third direction, where i is a natural number less than m.

In some embodiments, the channel signal region in each of the channels is divided into 2×2 via regions distributed in an array. Only for the multiple channel signal regions aligned in the third direction: A fourth via region belonging to the logic chip, a first via region belonging to the first memory chip, a second via region belonging to the second memory chip, a third via region belonging to the third memory chip, and a fourth via region belonging to the fourth memory chip are aligned in the third direction; a third via region belonging to the logic chip, a second via region belonging to the first memory chip, a first via region belonging to the second memory chip, a fourth via region belonging to the third memory chip, and a third via region belonging to the fourth memory chip are aligned in the third direction; a second via region belonging to the logic chip, a third via region belonging to the first memory chip, a fourth via region belonging to the second memory chip, a first via region belonging to the third memory chip, and a second via region belonging to the fourth memory chip are aligned in the third direction; and a first via region belonging to the logic chip, a fourth via region belonging to the first memory chip, a third via region belonging to the second memory chip, a second via region belonging to the third memory chip, and a first via region belonging to the fourth memory chip are aligned in the third direction.

In some embodiments, each of the via regions includes n conductive via groups with the same distribution position, each conductive via group has a third axis and a fourth axis, the third axis is parallel to the first axis, and the fourth axis and the third axis are perpendicular to each other and intersect at the center of the conductive via group to which the fourth axis and the third axis belong. When each of the conductive via groups includes a first conductive via, a second conductive via, a third conductive via, and a fourth conductive via that are distributed in a 2×2 array, the first conductive via and the second conductive via are symmetrical about the third axis of the conductive via group to which the first conductive via and the second conductive via belong, the third conductive via and the fourth conductive via are symmetrical about the third axis of the conductive via group to which the third conductive via and the fourth conductive via belong, and the first conductive via and the fourth conductive via are symmetrical about the fourth axis of the conductive via group to which the first conductive via and the fourth conductive via belong. Only for the multiple via regions aligned in the third direction: The fourth conductive via belonging to the logic chip, the first conductive via belonging to the first memory chip, the second conductive via belonging to the second memory chip, the third conductive via belonging to the third memory chip, and the fourth conductive via belonging to the fourth memory chip are aligned in the third direction; the third conductive via belonging to the logic chip, the second conductive via belonging to the first memory chip, the first conductive via belonging to the second memory chip, the fourth conductive via belonging to the third memory chip, and the third conductive via belonging to the fourth memory chip are aligned in the third direction; the second conductive via belonging to the logic chip, the third conductive via belonging to the first memory chip, the fourth conductive via belonging to the second memory chip, the first conductive via belonging to the third memory chip, and the second conductive via belonging to the fourth memory chip are aligned in the third direction; and the first conductive via belonging to the logic chip, the fourth conductive via belonging to the first memory chip, the third conductive via belonging to the second memory chip, the second conductive via belonging to the third memory chip, and the first conductive via belonging to the fourth memory chip are aligned in the third direction. The multiple conductive vias aligned in the third direction are coupled to form a conductive channel.

In some embodiments, the logic chip includes m channel signal regions arranged in a first direction, each of the memory chips has m channels arranged in the first direction, and each of the channels includes a first memory array region, a channel signal region, and a second memory array region that are sequentially distributed in a second direction. When the logic chip and the first memory chip are stacked in a back-to-back manner, and a first axis of the logic chip and a first axis of each of the memory chips extend in the first direction, the (i+1)th channel signal region in the logic chip is aligned with the channel signal region in the (i+1)th channel in the first memory chip, the channel signal region in the (i+1)th channel in the second memory chip, the channel signal region in the (m-i)th channel in the third memory chip, and the channel signal region in the (m-i)th channel in the fourth memory chip in the third direction, where i is a natural number less than m.

In some embodiments, the logic chip includes m channel signal regions arranged in the first direction, each of the memory chips has m channels arranged in the first direction, and each of the channels includes a first memory array region, a channel signal region, and a second memory array region that are sequentially distributed in the second direction. When the logic chip and the first memory chip are stacked in a back-to-back manner, and a second axis of the logic chip and a second axis of each of the memory chips extend in the first direction, the (m-i)th channel signal region in the logic chip is aligned with the channel signal region in the (i+1)th channel in the first memory chip, the channel signal region in the (m-i)th channel in the second memory chip, the channel signal region in the (m-i)th channel in the third memory chip, and the channel signal region in the (i+1)th channel in the fourth memory chip in the third direction, where i is a natural number less than m.

In some embodiments, only for the multiple channel signal regions aligned in the third direction: A second via region belonging to the logic chip, a first via region belonging to the first memory chip, a second via region belonging to the second memory chip, a third via region belonging to the third memory chip, and a fourth via region belonging to the fourth memory chip are aligned in the third direction; a first via region belonging to the logic chip, a second via region belonging to the first memory chip, a first via region belonging to the second memory chip, a fourth via region belonging to the third memory chip, and a third via region belonging to the fourth memory chip are aligned in the third direction; a fourth via region belonging to the logic chip, a third via region belonging to the first memory chip, a fourth via region belonging to the second memory chip, a first via region belonging to the third memory chip, and a second via region belonging to the fourth memory chip are aligned in the third direction; and a third via region belonging to the logic chip, a fourth via region belonging to the first memory chip, a third via region belonging to the second memory chip, a second via region belonging to the third memory chip, and a first via region belonging to the fourth memory chip are aligned in the third direction.

In some embodiments, each of the via regions includes n conductive via groups with the same distribution position, each conductive via group has a third axis and a fourth axis, the third axis is parallel to the first axis, and the fourth axis and the third axis are perpendicular to each other and intersect at the center of the conductive via group to which the fourth axis and the third axis belong. When each of the conductive via groups includes a first conductive via, a second conductive via, a third conductive via, and a fourth conductive via that are distributed in a 2×2 array, the first conductive via and the second conductive via are symmetrical about the third axis of the conductive via group to which the first conductive via and the second conductive via belong, the third conductive via and the fourth conductive via are symmetrical about the third axis of the conductive via group to which the third conductive via and the fourth conductive via belong, and the first conductive via and the fourth conductive via are symmetrical about the fourth axis of the conductive via group to which the first conductive via and the fourth conductive via belong. For the multiple via regions aligned in the third direction: The second conductive via belonging to the logic chip, the first conductive via belonging to the first memory chip, the second conductive via belonging to the second memory chip, the third conductive via belonging to the third memory chip, and the fourth conductive via belonging to the fourth memory chip are aligned in the third direction; the first conductive via belonging to the logic chip, the second conductive via belonging to the first memory chip, the first conductive via belonging to the second memory chip, the fourth conductive via belonging to the third memory chip, and the third conductive via belonging to the fourth memory chip are aligned in the third direction; the fourth conductive via belonging to the logic chip, the third conductive via belonging to the first memory chip, the fourth conductive via belonging to the second memory chip, the first conductive via belonging to the third memory chip, and the second conductive via belonging to the fourth memory chip are aligned in the third direction; and the third conductive via belonging to the logic chip, the fourth conductive via belonging to the first memory chip, the third conductive via belonging to the second memory chip, the second conductive via belonging to the third memory chip, and the first conductive via belonging to the fourth memory chip are aligned in the third direction. The multiple conductive vias aligned in the third direction are coupled to form a conductive channel.

In some embodiments, for two chips connected in a face-to-face manner, positions at which conductive vias in the two chips are aligned in the third direction are electrically connected through a hybrid bonding process; for two chips connected in a back-to-back manner or for two chips connected in a face-to-back manner, positions at which conductive vias in the two chips are aligned in the third direction are electrically connected through a conductive bump bonding process; or for two chips connected in a face-to-face manner, for two chips connected in a back-to-back manner, or for two chips connected in a face-to-back manner, positions aligned with conductive vias in the two chips in the third direction are electrically connected through a hybrid bonding process; or for two chips connected in a face-to-face manner, for two chips connected in a back-to-back manner, or for two chips connected in a face-to-back manner, positions aligned with conductive vias in the two chips in the third direction are electrically connected through a conductive bump bonding process.

According to a fourth aspect, an embodiment of the present disclosure provides a memory. The memory includes the chip stacked structure described in the third aspect.

The embodiments of the present disclosure provide a memory chip, a logic chip, a chip stacked structure, and a memory, to reduce a quantity of disposed driver circuits and data selectors, so that parasitic capacitance is reduced. In addition, a chip stacked structure formed by memory chips implements a signal rotation transmission effect with a direct connection configuration of vias, and further reduces parasitic resistance.

### BRIEF DESCRIPTION OF DRAWINGS

FIG. 1 is a schematic structural diagram of a chip;
FIG. 2A is a schematic diagram of signal transmission of a chip stacked structure;
FIG. 2B is a schematic diagram of signal transmission of a chip stacked structure;
FIG. 3 is a schematic structural diagram of a memory chip according to an embodiment of the present disclosure;
FIG. 4 is a schematic diagram 1 of a partial structure of a memory chip according to an embodiment of the present disclosure;
FIG. 5 is a schematic diagram 2 of a partial structure of a memory chip according to an embodiment of the present disclosure;
FIG. 6 is a schematic structural diagram of a logic chip according to an embodiment of the present disclosure;
FIG. 7A is a schematic diagram 1 of a partial structure of a logic chip according to an embodiment of this disclosure;
FIG. 7B is a schematic diagram 2 of a partial structure of a logic chip according to an embodiment of the present disclosure;
FIG. 8 is a schematic diagram of a chip stacked structure according to an embodiment of the present disclosure;
FIG. 9A is a specific schematic diagram 1 of a chip stacked structure according to an embodiment of the present disclosure;
FIG. 9B is a specific schematic diagram 2 of a chip stacked structure according to an embodiment of the present disclosure;
FIG. 10A is a specific schematic diagram 1 of another chip stacked structure according to an embodiment of the present disclosure;
FIG. 10B is a specific schematic diagram 2 of another chip stacked structure according to an embodiment of the present disclosure;
FIG. 11A is a specific schematic diagram 1 of still another chip stacked structure according to an embodiment of the present disclosure;
FIG. 11B is a specific schematic diagram 2 of still another chip stacked structure according to an embodiment of the present disclosure;
FIG. 12A is a specific schematic diagram 1 of yet another chip stacked structure according to an embodiment of the present disclosure;
FIG. 12B is a specific schematic diagram 2 of yet another chip stacked structure according to an embodiment of the present disclosure;
FIG. 13 is a schematic diagram 1 of signal transmission of a chip stacked structure according to an embodiment of the present disclosure;
FIG. 14 is a schematic diagram 2 of signal transmission of a chip stacked structure according to an embodiment of the present disclosure; and
FIG. 15 is a schematic structural diagram of a memory according to an embodiment of the present disclosure.

### DESCRIPTION OF EMBODIMENTS

The technical solutions in the embodiments of the present disclosure are clearly described below with reference to the accompanying drawings in the embodiments of the present disclosure. It may be understood that specific embodiments described herein are merely intended to explain the related application, but are not intended to limit this application. In addition, it should be further noted that for ease of description, only parts related to the related application are shown in the accompanying drawings. Unless otherwise defined, all technical and scientific terms used in this specification have meanings the same as those commonly understood by a person skilled in the technical field of the present disclosure. The terms used in this specification are merely intended to describe the embodiments of the present disclosure, but are not intended to limit the present disclosure. The following descriptions relate to "some embodiments" describing a subset of all possible embodiments. However, it may be understood that "some embodiments" may be the same subset or different subsets of all the possible embodiments, and may be combined with each other when there is no conflict. It should be noted that the term "first/second/third" in the embodiments of the present disclosure is merely intended to distinguish between similar objects, and does not represent specific sorting for the objects. It may be understood that "first/second/third" may be interchanged for a specific sequence or order if allowed, so that the embodiments of the present disclosure described herein can be implemented in a sequence other than those shown or described.
dynamic random access memory (DRAM);
synchronous dynamic random access memory (SDRAM);
double data rate SDRAM (DDR);
low power DDR (LPDDR).

Before the embodiments of the present disclosure are described, three directions that may be used to describe three-dimensional structures in planes in the following embodiments are first defined. In an example of a Cartesian coordinate system, the three directions may include a first direction, a second direction, and a third direction.

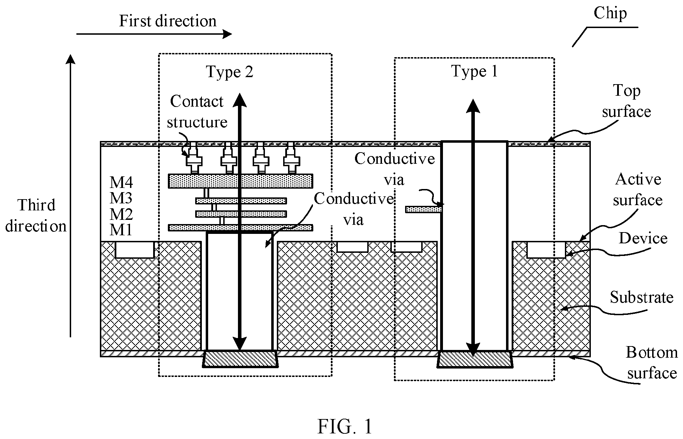

Refer to FIG. 1. A semiconductor chip (which may be specifically a memory chip or a logic chip) may include a top surface located on the front and a bottom surface located on the back opposite to the front. When flatness of the top surface and the bottom surface is ignored, a direction intersecting with (e.g., perpendicular to) the top surface and the bottom surface of the semiconductor chip is defined as a third direction. Two directions, namely, a first direction and a second direction, that are perpendicular to each other are defined on the top surface of the semiconductor chip. The first direction is perpendicular to an edge of the semiconductor chip, and the second direction is perpendicular to another edge of the semiconductor chip.

Refer to FIG. 1. The semiconductor chip includes a substrate, and an active surface is formed by a surface that is of the substrate and that is configured to manufacture a device (e.g., a transistor or a capacitor) (a surface opposite to the active surface in the substrate is a non-active surface, that is, the bottom surface in FIG. 1). Multiple metal layers, e.g., M1, M2, and M3, are distributed between the substrate and the top surface of the semiconductor chip. Two types of conductive vias (e.g., through silicon vias) are further shown in FIG. 1, and are both configured to implement signal connections between different stacked chips.

As shown in FIG. 1, a conductive via of a type 1 penetrates through the bottom surface and the top surface in the third direction, and the conductive via is connected to an internal circuit of the chip through a metal layer.

As shown in FIG. 1, a conductive via of a type 2 penetrates only through the substrate (penetrates through the active surface and the bottom surface) in the third direction, and needs to cooperate with contact structures penetrating through the top surface in the third direction to jointly implement signal transmission. The contact structures are not directly electrically connected to the conductive via, but indirectly electrically connected to the conductive via through the metal layers. For example, the contact structures in FIG. 1 are connected to M4, M4 is connected to M1 after being sequentially connected to M3 and M2, and M1 is connected to the conductive via. Alternatively, the conductive via in FIG. 1 is connected to an input terminal of the internal circuit (the device in the substrate in FIG. 1) of the chip through M1 to M4, and an output signal processed by the internal circuit of the chip is then output to the corresponding contact structures through the metal layers M1 to M4. Similarly, the contact structures in FIG. 1 may also be connected to the input terminal of the internal circuit (the device in the substrate in FIG. 1) of the chip through M1 to M4, and an output signal processed by the internal circuit of the chip is then output to the corresponding conductive via through M1 to M4. Certainly, in another embodiment, the contact structures and the conductive via may alternatively be designed in a direct electric connection.

In addition, types of conductive vias are not limited to the foregoing two types, which are only examples. In particular, the diagrams presented in the present disclosure are not intended to represent actual views of any specific microelectronic apparatus or components thereof, but are only idealized representations for describing illustrative embodiments. Therefore, the diagrams are not necessarily drawn to scale.

The following describes the embodiments of the present disclosure in detail with reference to the accompanying drawings.

In an embodiment, a memory chip and a logic chip are provided. The memory chip/logic chip includes multiple conductive vias penetrating through the chip in a third direction. The conductive vias are configured to implement signal transmission between different chips, and all the conductive vias may be located at any location. In particular, every four conductive vias may be functionally considered as a conductive via group, but positions of the four conductive vias are not limited.

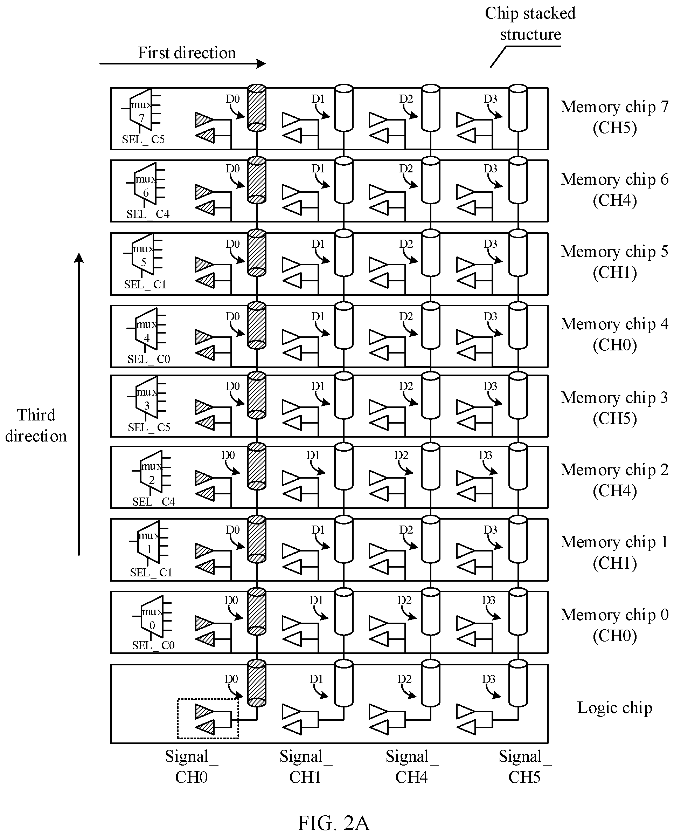

In a specific embodiment, eight foregoing memory chips and one logic chip are stacked to form a 3D memory device, and conductive vias of the eight memory chips are aligned in the third direction, and nine conductive vias aligned in the third direction are connected to form an electrical path. FIG. 2A shows a schematic diagram of signal transmission of a chip stacked structure. As shown in FIG. 2A, the chip stacked structure includes memory chips 0~7 and a logic chip. In FIG. 2A, only four conductive vias D0~D3 are shown for each memory chip, and the four conductive vias D0~D3 belong to the same conductive via group. In this case, conductive vias D0 in the eight memory chips and one logic chip are all aligned to form one electrical path, conductive vias D1 in the eight memory chips and one logic chip are all aligned to form one electrical path, and there is a similar case for the remaining conductive vias.

In addition, multiple driver circuits are further disposed in each memory chip and the logic chip (in FIG. 2A, only one driver circuit is shown in a dotted line box, and the remaining driver circuits are not shown in boxes), and each conductive via is connected to one driver circuit. Multiple data selectors (e.g., mux0~mux7 in FIG. 2A) are further disposed in each memory chip, and each conductive via group corresponds to one data selector, that is, all conductive vias in one conductive via group are connected to a data port of the data selector through respective driver circuits. That is, the data selector may choose to output, to the inside of the memory chip, a signal transmitted by a specific conductive via or output, to a specific conductive via, a signal output by the memory chip.

For an overall memory device, different regions in different memory chips are classified into different channels (e.g., CH0, CH1, CH4, and CH5) for management. A signal Signal_CH0 of the channel CH0 is transmitted through an electrical path, namely, "the conductive via D0 in the logic chip and the conductive via D0 in the memory chip 0 -- the conductive via D0 in the memory chip 1 -- the conductive via D0 in the memory chip 2 -- the conductive via D0 in the memory chip 3 -- the conductive via D0 in the memory chip 4 -- the conductive via D0 in the memory chip 5 -- the conductive via D0 in the memory chip 6 -- the conductive via D0 in the memory chip 7". Selection signals of the data selector mux0 in the memory chip 0 and the data selector mux4 in the memory chip 4 are SEL_C0, that is, the signal Signal_CH0 may enter the memory chip 0 and the memory chip 4 through the foregoing electrical path. A signal output procedure may be similarly understood.

It may be learned from the foregoing description that the memory chip 0 needs to obtain a signal only from the conductive via D0, the memory chip 1 needs to obtain a signal only from the conductive via D1, and so on. That is, each memory chip needs to obtain a signal only from one conductive via in a conductive via group. It should be noted that different memory chips may need to obtain signals from different conductive vias. However, during process manufacturing, all the memory chips need to be designed into an exactly same structure (to maximize cost and labor savings). Therefore, all conductive vias in the memory chips need to be designed with corresponding driver structures and data selectors, to implement structural consistency. Further, when the chip stacked structure shown in FIG. 2A is used, each conductive via corresponds to one driver circuit. All driver circuits in all memory chips in the same channel need to be driven in a working procedure of the chip stacked structure, resulting in a relatively heavy load and relatively high parasitic capacitance. This severely affects performance of the chips in the chip stacked structure, restricts transmission efficiency, increases power consumption, and restricts a quantity of stacked chips in a three-dimensional device.

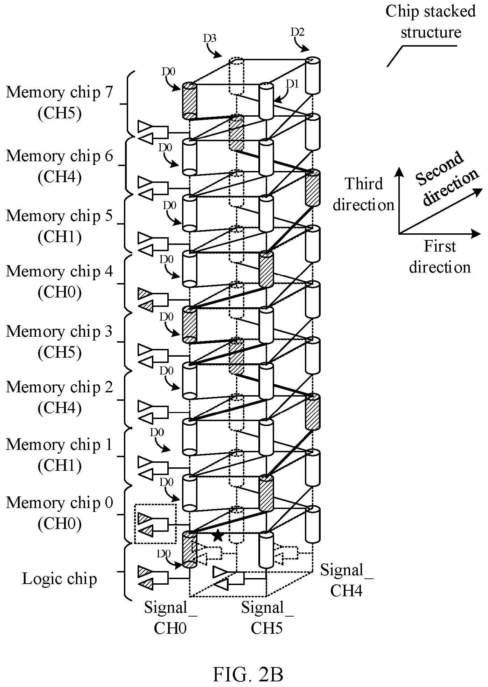

In another embodiment, FIG. 2B shows a schematic diagram of signal transmission of another chip stacked structure. In particular, in FIG. 2B, only some conductive vias (D0~D3) are marked, and other conductive vias are not marked. However, for FIG. 2B, markings of conductive vias aligned in the third direction are the same. As shown in FIG. 2B, the chip stacked structure also includes eight memory chips and one logic chip that are aligned in the third direction. However, each of conductive vias in each memory chip is rotatably connected to another conductive via at a different position in another memory chip, to implement an overall spiral ascending connection. That is, a signal Signal_CH0 of a channel CH0 is transmitted through "the conductive via D0 in the logic chip -- the conductive via D1 in the memory chip 0 -- the conductive via D2 in the memory chip 1 -- the conductive via D3 in the memory chip 2 -- the conductive via D0 in the memory chip 3 -- the conductive via D1 in the memory chip 4 -- the conductive via D2 in the memory chip 5 -- the conductive via D3 in the memory chip 6 -- the conductive via D0 in the memory chip 7", and there is a similar case for the remaining signals.

In this way, the memory chip 0 can obtain the signal Signal_CH0 through an output terminal of the conductive via D0 in the logic chip, the memory chip 1 can obtain a signal Signal_CH1 through an input terminal of the conductive via D0 in the memory chip 0, the memory chip 2 can obtain a signal Signal_CH4 through an input terminal of the conductive via D0 in the memory chip 1, the memory chip 3 can obtain a signal Signal_CH5 through an input terminal of the conductive via D0 in the memory chip 2, and so on. For each memory chip, only one conductive via in each conductive via group needs to be connected to a driver circuit, and no data selector needs to be disposed. This can reduce a quantity of devices, thereby reducing parasitic capacitance. However, compared with the direct connection configuration of the conductive vias in FIG. 2A, the process of rotatably connecting the conductive vias in FIG. 2B is more complex. Specifically, an interconnection structure in a horizontal direction needs to be disposed between adjacent conductive vias in each memory chip in FIG. 2B (only one interconnection structure is marked with a five-pointed star in FIG. 2B). The signal interconnection structure may be a metal interconnection line, a conductive via, or the like. To implement the rotatable connection between the conductive vias, the input signal signal_CH0 needs to be first transmitted upward from the conductive via D0 in the logic chip to an interconnection structure (not connected to the conductive via D0 in the memory chip 0) below the conductive via D0 in the memory chip 0, and then horizontally transmitted from the interconnection structure below the conductive via D0 in the memory chip 0 to the conductive via D1 in the memory chip 0. That is, in a signal transmission procedure, the interconnection structure in each memory chip further needs to be used in the structure shown in FIG. 2B, and there is a similar case for an output signal. This inevitably increases parasitic resistance and increases process complexity.

In particular, in the chip stacked structures shown in FIG. 2A and FIG. 2B, the active surfaces of all the chips face upward, that is, different memory chips are stacked in a back-to-face manner, and the memory chip and the logic chip are also stacked in a back-to-face manner, that is, the bottom surface of the upper chip is in contact with the top surface of a lower chip.

In conclusion, on one hand, in the chip stacked structure in FIG. 2A, a relatively large quantity of conductive vias need to be disposed to transmit corresponding signals, and corresponding driver circuits and data selectors are further disposed, resulting in a relatively heavy load and relatively high parasitic capacitance, and the chip stacked structure in FIG. 2B has relatively high parasitic resistance due to the rotatable configuration. On the other hand, the stacked structure in FIG. 2A and the stacked structure in FIG. 2B each have some problems, and cannot be directly applicable to a face-to-face stacked structure. Specifically, if the face-to-face chip-stacked structure needs to be further implemented, one manner is to use two sets of masks to manufacture two different chips that are respectively used as a chip with an active surface facing upward and a chip with an active surface facing downward. In this manner, process complexity is relatively high, and costs are uncontrollable. Another manner is to manufacture an additional group of conductive vias and connect both groups of conductive vias to the same driver circuit in a memory chip. However, this results in complex internal wiring of the memory chip, which not only increases process complexity but also increases power consumption.

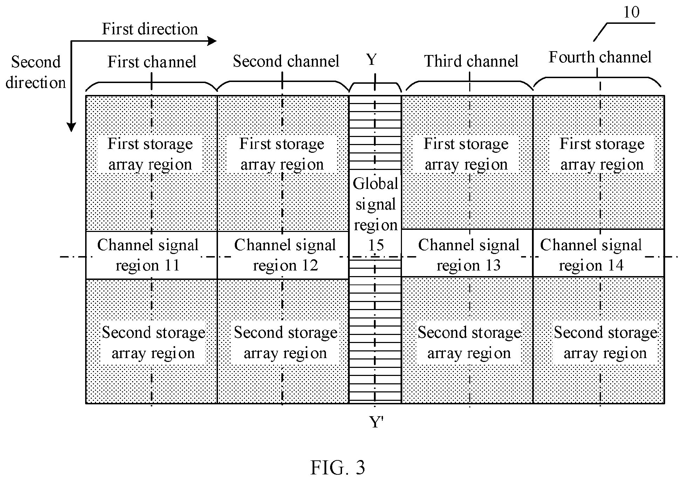

In still another embodiment of the present disclosure, FIG. 3 shows a schematic structural diagram of a memory chip 10 according to an embodiment of the present disclosure. As shown in FIG. 3, the memory chip 10 includes m channels (FIG. 3 illustrates an example in which m=4). The m channels are sequentially arranged in a first direction, the memory chip 10 has a chip axis YY' extending in a second direction and passing through a center of the memory chip, and the m channels are symmetrical about the chip axis YY'. Each channel includes a first memory array region, a channel signal region, and a second memory array region that are sequentially distributed in the second direction, and a center of each channel signal region coincides with a center of a channel to which the channel signal region belongs.

It should be noted that in a chip manufacturing procedure, to distinguish between different channels of the chip, a positioning structure may be manufactured in a reference channel (e.g., a first channel) of the memory chip 10, so that during subsequent packaging, a position of the reference channel is identified through the positioning structure, and another channel is identified with reference to an orientation of the active surface of the chip.

FIG. 3 illustrates an example in which m=4. m=4 is also used as an example for description in the following. However, m may be any positive integer. Specifically, if m is an even number, m/2 channels are located on one side of a global signal region 15 in the first direction, and the remaining m/2 channels are located on the other side of the global signal region 15 in the first direction. If m is an odd number, the ((m+1)/2)th channel needs to be divided into two parts, which are respectively located on two sides of the global signal region 15 in the first direction, while the other (m-1)/2 channels are located on one side of the global signal region 15 in the first direction, and the remaining (m-1)/2 channels are located on the other side of the global signal region 15 in the first direction.

FIG. 3 may be considered as a cross-sectional view of the active surface of the memory chip. As shown in FIG. 3, the center of the active surface of the memory chip and a proximity area of the center are defined as the global signal region 15. In this case, the first channel, a second channel, the global signal region 15, a third channel, and a fourth channel are sequentially distributed in the first direction. A signal transmitted by the global signal region 15 is commonly used by the m channels of the memory chip. A signal transmitted by each channel signal region is only used by the channel to which the channel signal region belongs.

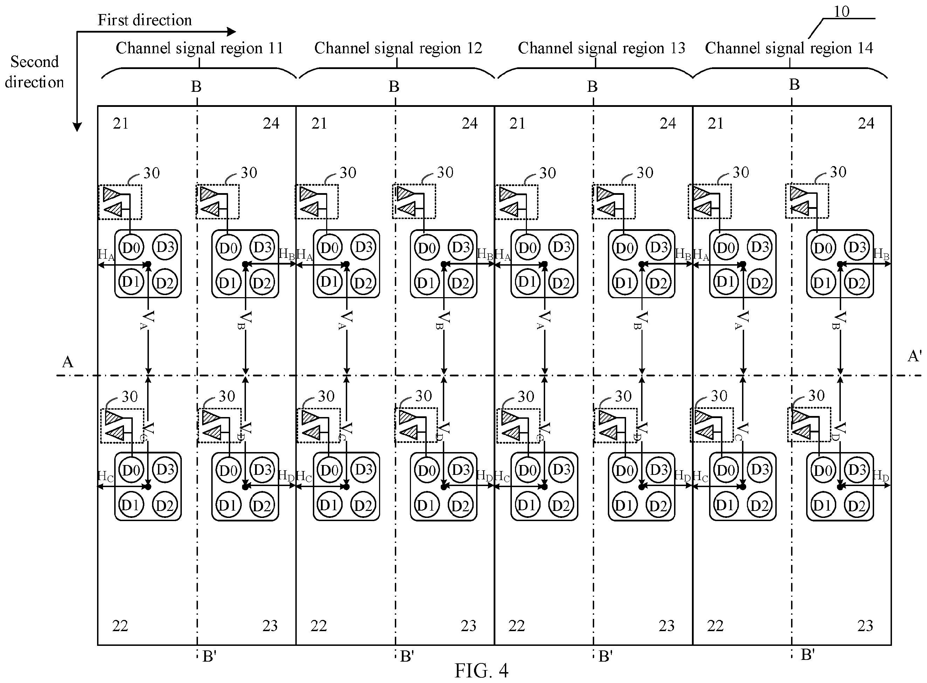

FIG. 4 specifically shows a schematic diagram of a channel signal region 11 of the first channel, a channel signal region 12 of the second channel, a channel signal region 13 of the third channel, and a channel signal region 14 of the fourth channel. FIG. 4 omits the global signal region 15.

As shown in FIG. 4, each channel signal region has a first axis AA' and a second axis BB', the first axis AA' extends in the first direction or in the second direction, and the second axis BB' and the first axis AA' are perpendicular to each other and intersect at the center of the channel signal region to which the second axis and the first axis belong. FIG. 4 illustrates an example in which the first axis AA' extends in the first direction. In another case, adaptive understanding is required.

Each channel signal region is divided into 2×2 via regions distributed in an array. A first via region 21 and a second via region 22 are symmetrical along the first axis AA' of the channel signal region to which the first via region and the second via region belong, a third via region 23 and a fourth via region 24 are symmetrical along the first axis AA' of the channel signal region to which the third via region and the fourth via region belong, and the first via region 21 and the fourth via region 24 are symmetrical along the second axis BB' of the channel signal region to which the first via region and the fourth via region belong.

Each via region includes n conductive via groups (FIG. 4 shows only a part of the conductive via groups), the n conductive via groups penetrate through a substrate of the memory chip 10 in a direction perpendicular to the active surface of the memory chip 10, and n is a natural number.

In addition, the areas of the m channel signal regions are the same, and distribution positions of the conductive via groups in the m channel signal regions are the same. In this way, during manufacturing of the memory chip 10, layouts (Layout) of the channel signal regions of different channels are completely the same, and a same mask plate may be used to reduce manufacturing costs.

Specifically, in the same channel signal region, n conductive via groups in the first via region 21 and n conductive via groups in the second via region 22 are symmetrical about the first axis AA' of the channel signal region to which the conductive via groups belong, n conductive via groups in the third via region 23 and n conductive via groups in the fourth via region 24 are symmetrical about the first axis AA' of the channel signal region to which the conductive via groups belong, and the n conductive via groups in the first via region 21 and the n conductive via groups in the fourth via region 24 are symmetrical about the second axis BB' of the channel signal region to which the conductive via groups belong.

As shown in FIG. 4, a distance between the center of a conductive via group in the first via region 21 and the first axis AA' is denoted as V_{A}, a distance between the center of a conductive via group that is in the second via region 22 and that is symmetrical to that in the first via region and the first axis AA' is denoted as V_{C}, a distance between the center of a conductive via group that is in the third via region 23 and that is symmetrical to that in the second via region and the first axis AA' is denoted as V_{D}, and a distance between the center of a conductive via group that is in the fourth via region 24 and that is symmetrical to that in the first via region and the first axis AA' is denoted as V_{B}. In this case, V_{A}=V_{C}=V_{D}=V_{B}. Similarly, a distance between the center of a conductive via group in the first via region 21 and an edge that is of the channel signal region and that extends in the second direction is denoted as H_{A}, a distance between the center of a conductive via group in the second via region 22 and the edge that is of the channel signal region and that extends in the second direction is denoted as H_{C}, a distance between the center of a conductive via group in the third via region 23 and another edge that is of the channel signal region and that extends in the second direction is denoted as H_{D}, and a distance between the center of a conductive via group in the fourth via region 24 and the edge that is of the channel signal region and that extends in the second direction is denoted as H_{B}. In this case, H_{A}=H_{C}=H_{D}=H_{B}.

It should be noted that a quantity and specific positions of conductive vias in a conductive via group have very flexible options. For example, each conductive via group may have only one conductive via, or have 1×2 vias, or have 2×2 vias, or have 2×3 vias, and only needs to ensure that conductive via groups in different via regions follow the foregoing symmetrical relationships.

The following uses only an example in which each conductive via group includes 2×2 conductive vias (D0, D1, D2, and D3) distributed in an array for specific description. In another case, adaptive understanding is required.

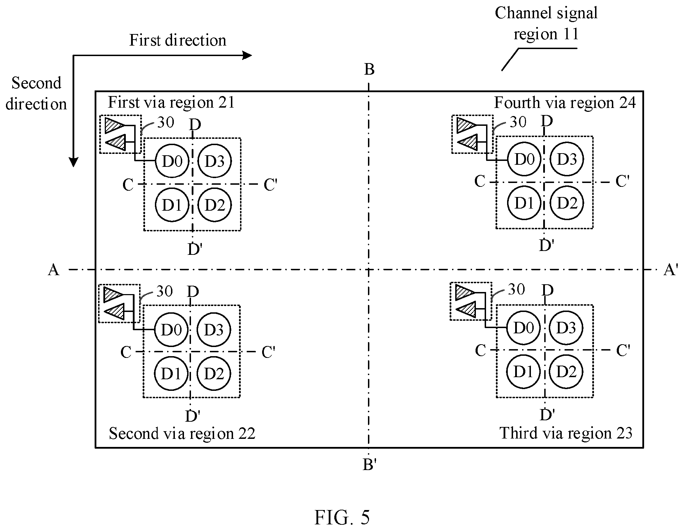

Refer to FIG. 5. Each conductive via group has a third axis CC' and a fourth axis DD', the third axis CC' is parallel to the first axis AA', and the fourth axis DD' and the third axis CC' are perpendicular to each other and intersect at the center of the conductive via group to which they belong. The first conductive via D0 and the second conductive via D1 are symmetrical about the third axis CC' of the conductive via group to which the first conductive via and the second conductive via belong, the third conductive via D2 and the fourth conductive via D3 are symmetrical about the third axis CC' of the conductive via group to which the third conductive via and the fourth conductive via belong, and the first conductive via D0 and the fourth conductive via D3 are symmetrical about the fourth axis DD' of the conductive via group to which the first conductive via and the fourth conductive via belong.

In this way, an overall arrangement formed by a conductive via group in the first via region 21, a corresponding conductive via group in the second via region 22, a corresponding conductive via group in the third via region 23, and a corresponding conductive via group in the fourth via region 24 is symmetrical about the first axis AA' and symmetrical about the second axis BB'. For each conductive via group, the first via, the second via, the third via, and the fourth via are symmetrical about the third axis CC' and symmetrical about the fourth axis DD', so that when a chip stacked structure is subsequently formed, a point-to-point direct connection conductive path can be formed, to reduce parasitic capacitance and parasitic resistance. For details, refer to the following description.

In some embodiments, with reference to FIG. 4, the following symmetrical relationships exist in each channel signal region:
(1) n first conductive vias D0 in the first via region 21 and n second conductive vias D1 in the second via region 22 are symmetrical about the first axis AA' of the channel signal region to which the n first conductive vias and the n second conductive vias belong, n third conductive vias D2 in the third via region 23 and n fourth conductive vias D3 in the fourth via region 24 are symmetrical about the first axis AA' of the channel signal region to which the n third conductive vias and the n fourth conductive vias belong, and the n first conductive vias D0 in the first via region 21 and the n fourth conductive vias D3 in the fourth via region 24 are symmetrical about the second axis BB' of the channel signal region to which the n first conductive vias and the n fourth conductive vias belong;
(2) n second conductive vias D1 in the first via region 21 and n first conductive vias D0 in the second via region 22 are symmetrical about the first axis AA' of the channel signal region to which the n second conductive vias and the n first conductive vias belong, n fourth conductive vias D3 in the third via region 23 and n third conductive vias D2 in the fourth via region 24 are symmetrical about the first axis AA' of the channel signal region to which the n fourth conductive vias and the n third conductive vias belong, and the n second conductive vias D1 in the first via region 21 and the n third conductive vias D2 in the fourth via region 24 are symmetrical about the second axis BB' of the channel signal region to which the n second conductive vias and the n third conductive vias belong;
(3) n third conductive vias D2 in the first via region 21 and n fourth conductive vias D3 in the second via region 22 are symmetrical about the first axis AA' of the channel signal region to which the n third conductive vias and the n fourth conductive vias belong, n first conductive vias D0 in the third via region 23 and n second conductive vias D1 in the fourth via region 24 are symmetrical about the first axis AA' of the channel signal region to which the n first conductive vias and the n second conductive vias belong, and the n third conductive vias D2 in the first via region 21 and the n second conductive vias D1 in the fourth via region 24 are symmetrical about the second axis BB' of the channel signal region to which the n third conductive vias and the n second conductive vias belong; and
(4) n fourth conductive vias D3 in the first via region 21 and n third conductive vias D2 in the second via region 22 are symmetrical about the first axis AA' of the channel signal region to which the n fourth conductive vias and the n third conductive vias belong, n second conductive vias D1 in the third via region 23 and n first conductive vias D0 in the fourth via region 24 are symmetrical about the first axis AA' of the channel signal region to which the n second conductive vias and the n first conductive vias belong, and the n fourth conductive vias D3 in the first via region 21 and the n first conductive vias D0 in the fourth via region 24 are symmetrical about the second axis BB' of the channel signal region to which the n fourth conductive vias and the n first conductive vias belong.

In some embodiments, with reference to FIG. 4 or FIG. 5, the memory chip 10 further includes (4×m×n) first driver circuits 30. The (4×m×n) first driver circuits 30 are coupled to (4×m×n) first conductive vias D0 in a one-to-one correspondence. Specifically, the first driver circuits 30 are coupled to parts that are of the first conductive vias D0 and that are located on the active surface. The first driver circuits 30 are configured to send signals transmitted by the correspondingly connected first conductive vias D0 to an internal circuit of the memory chip 10, or send signals generated by an internal circuit of the memory chip 10 to the correspondingly connected first conductive vias.

In this way, for each conductive via group, only the first conductive via D0 in the conductive via group is connected to the internal circuit of the memory chip through the first driver circuit 30, and no data selector needs to be disposed to select a via, so that a quantity of devices can be reduced, thereby reducing parasitic capacitance.

In some embodiments, a coordinate position of each conductive via is determined based on the center of the channel signal region to which the conductive via belongs, and types of signals transmitted by four conductive vias with the same coordinate position are the same.

For example, for a chip stacked structure including multiple memory chips and a logic chip, multiple chip select signals CS_0, CS_1, CS_2, and the like exist, and are respectively used to indicate whether memory array regions of different channels are selected. In this case, as shown in FIG. 4, a first conductive via D0 located in the first via region 21 in the channel signal region 11, a first conductive via D0 located in the same position in the first via region 21 in the channel signal region 12, a first conductive via D0 located in the same position in the first via region 21 in the channel signal region 13, and a first conductive via D0 located in the same position in the first via region 21 in the channel signal region 14 each transmit a chip select signal CS, but values of the chip select signals transmitted by the first conductive vias D0 in different channel signal regions may be different, for example, the first conductive via D0 in the first via region 21 in the channel signal region 11 is configured to transmit CS_0 (corresponding to the first channel in the first memory chip), the first conductive via D0 in the first via region 21 in the channel signal region 12 is configured to transmit CS_1 (corresponding to the first channel in the second memory chip), the first conductive via D0 in the first via region 21 in the channel signal region 13 is configured to transmit CS_2 (corresponding to the fourth channel in the third memory chip), and so on.

In addition, for the same channel signal region, types of signals transmitted by four conductive vias that are in the channel signal region and that are symmetrical along the first axis and along the second axis are the same, but specific signal values may be different.

In some embodiments, a conductive via may at least be embodied as a through silicon via (TSV), which is specifically a vertical interconnection structure that penetrates through a silicon wafer/memory chip, for example, the type 1 in FIG. 1. Certainly, the conductive via may alternatively be of the type 2 in FIG. 1, and the conductive via and a contact structure jointly implement signal transmission. In another embodiment, another electrical connection structure may be used as a conductive via.

The conductive vias are manufactured through any one or more of a via-first process (via-first), a via-middle process (via-middle), a via-last process (via-last), and a back side via-last process (back side via-last); and different conductive vias in the same memory chip (10) are electrically isolated.

It should be noted that the via-first process is a via process method in which a via structure is first manufactured before a structure of a device such as a metal oxide semiconductor field effect transistor (MOSFET or MOS transistor for short) device is manufactured. The via-middle process is a via process in which a via structure formed in a manufacturing procedure of a process flow is usually manufactured after a device is formed and before a stacked layer is manufactured. The via-last process is a manufacturing process in which a via is formed from the front of a wafer after processing of a back end of line (BEOL) process is completed. The back side via-last process is a manufacturing process in which a via structure is manufactured from the back of the wafer after processing of the BEOL process is completed. That is, the via-first process may refer to manufacturing vias first, and then manufacturing a circuit; the via-middle process may refer to manufacturing a circuit and some metal layers, then manufacturing vias, and finally manufacturing remaining vias; and the via-last process and the back side via-last process may refer to manufacturing a circuit and a metal layer first, and finally manufacturing vias.

In this way, this embodiment of the present disclosure provides a memory chip 10, including multiple channels. The multiple channels are symmetrical about a chip axis. Conductive vias in each channel are symmetrical about a first axis and a second axis, which can be directly applicable to a face-to-face stacked structure without use of two sets of masks or two sets of vias. In addition, only one conductive via in each conductive via group is connected to a driver circuit, and no data selector needs to be disposed for via selection, so that a quantity of devices can be reduced. Therefore, compared with the memory chip in FIG. 2A, parasitic capacitance is reduced, a circuit area is reduced, and chip manufacturing costs are also reduced. Subsequently, when a stacked structure is formed, a point-to-point direct connection conductive path is formed in the memory chip 10, and parasitic resistance may further be reduced compared with the memory chip in FIG. 2B (for a specific reason, refer to the following descriptions).

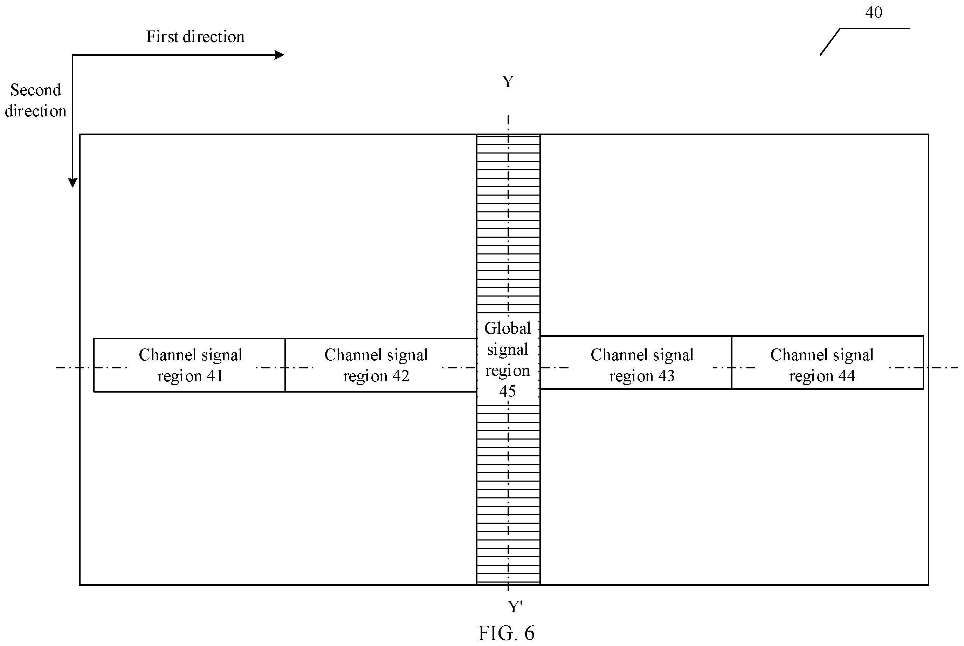

In yet another embodiment of the present disclosure, FIG. 6 shows a schematic structural diagram of a logic chip 40 according to an embodiment of the present disclosure. As shown in FIG. 6, the logic chip 40 includes m channel signal regions (FIG. 6 illustrates an example in which m=4). The m channel signal regions are sequentially arranged in a first direction, the logic chip 40 has a chip axis YY' extending in a second direction and passing through a center of the logic chip 40, and the m channel signal regions are symmetrical about the chip axis YY'. Herein, an area of a channel signal region in the logic chip 40 is the same as an area of a channel signal region in a memory chip.

Similarly, as shown in FIG. 6, a center of an active surface of the logic chip 40 and a proximity region of the center are also defined as a global signal region 45. In this case, a first channel signal region 41, a second channel signal region 42, the global signal region 45, a third channel signal region 43, and a fourth channel signal region 44 are sequentially distributed in the first direction. However, the logic chip does not have a memory array region, to be specific, what on two sides of each channel signal region of the logic chip 40 are not storage unit arrays, but are some logic control circuits of a stacked memory. A signal transmitted by the global signal region 45 is commonly used by m channels of the memory chip. However, a signal transmitted by each channel signal region is only used by a channel to which the channel signal region belongs. In particular, the area of the active surface of the logic chip 40 may be the same as the area of the active surface of the memory chip 10, or the area of the logic chip 40 may be greater than the area of the memory chip 10.

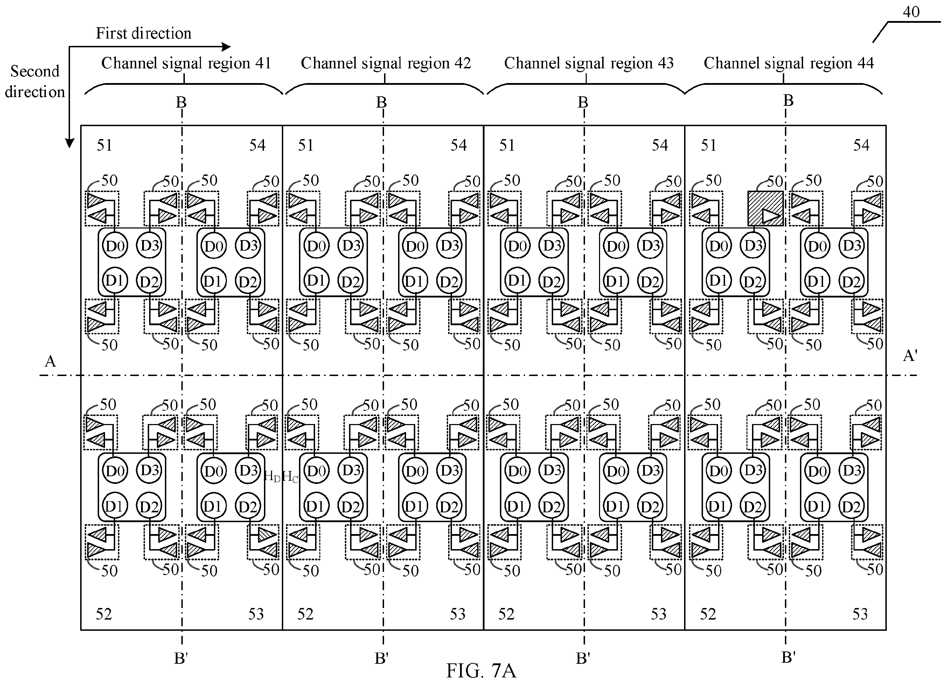

As shown in FIG. 7A, each channel signal region has a first axis AA' and a second axis BB', the first axis AA' extends in the first direction or the second direction (FIG. 7A shows an example in which the first axis AA' extends in the first direction), and the second axis BB' and the first axis AA' are perpendicular to each other and intersect at a center of the channel signal region to which the second axis and the first axis belong. Each channel signal region is divided into 2×2 via regions distributed in an array, a first via region 51 and a second via region 52 are symmetrical along the first axis AA' of the channel signal region to which the first via region and the second via region belong, a third via region 53 and a fourth via region 54 are symmetrical along the first axis AA' of the channel signal region to which the third via region and the fourth via region belong, and the first via region 51 and the fourth via region 54 are symmetrical along the second axis BB' of the channel signal region to which the first via region and the fourth via region belong. The second direction is perpendicular to the first direction.

Each via region includes n conductive via groups, the n conductive via groups penetrate through a substrate of the logic chip 40 in a direction perpendicular to the active surface of the logic chip, and n is a natural number. Areas of the m channel signal regions are the same, and distribution positions of the conductive via groups in the m channel signal regions are the same. In the same channel signal region, n conductive via groups in the first via region 51 and n conductive via groups in the second via region 52 are symmetrical about the first axis AA' of the channel signal region to which the conductive via groups belong, n conductive via groups in the third via region 53 and n conductive via groups in the fourth via region 54 are symmetrical about the first axis AA' of the channel signal region to which the conductive via groups belong, and the n conductive via groups in the first via region 51 and the n conductive via groups in the fourth via region 54 are symmetrical about the second axis BB' of the channel signal region to which the conductive via groups belong.

Similarly, for the logic chip 40, a quantity and positions of conductive vias included in a conductive vias group may be flexibly determined. The following uses only an example in which each conductive vias group includes 2×2 conductive vias (D0, D1, D2, and D3) distributed in an array for description.

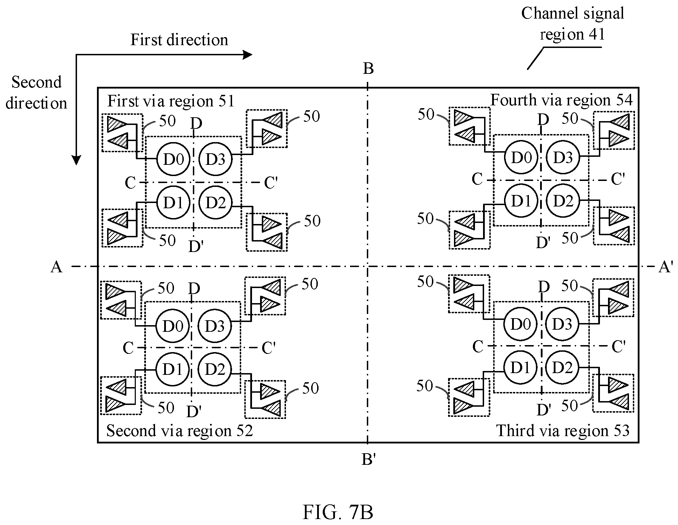

As shown in FIG. 7B, each conductive via group has a third axis CC' and a fourth axis DD', the third axis CC' is parallel to the first axis AA', and the fourth axis DD' and the third axis CC' are perpendicular to each other and intersect at the center of the conductive via group to which they belong. The first conductive via D0 and the second conductive via D1 are symmetrical about the third axis CC' of the conductive via group to which the first conductive via and the second conductive via belong, the third conductive via D2 and the fourth conductive via D3 are symmetrical about the third axis CC' of the conductive via group to which the third conductive via and the fourth conductive via belong, and the first conductive via D0 and the fourth conductive via D3 are symmetrical about the fourth axis DD' of the conductive via group to which the first conductive via and the fourth conductive via belong.

Similarly, for the logic chip 40, the areas of the m channel signal regions are the same, and the distribution positions of the conductive via groups in the m channel signal regions are the same. In this way, during manufacturing of the logic chip 40, layouts (Layout) of the channel signal regions of different channels are completely the same, and a same mask plate may be used to reduce manufacturing costs.

In some embodiments, with reference to FIG. 7A, the following symmetrical relationships exist in each channel signal region:
(1) n first conductive vias D0 in the first via region 51 and n second conductive vias D1 in the second via region 52 are symmetrical about the first axis AA' of the channel signal region to which the n first conductive vias and the n second conductive vias belong, n third conductive vias D2 in the third via region 53 and n fourth conductive vias D3 in the fourth via region 54 are symmetrical about the first axis AA' of the channel signal region to which the n third conductive vias and the n fourth conductive vias belong, and the n first conductive vias D0 in the first via region 51 and the n fourth conductive vias D3 in the fourth via region 54 are symmetrical about the second axis BB' of the channel signal region to which the n first conductive vias and the n fourth conductive vias belong;
(2) n second conductive vias D1 in the first via region 51 and n first conductive vias D0 in the second via region 52 are symmetrical about the first axis AA' of the channel signal region to which the n second conductive vias and the n first conductive vias belong, n fourth conductive vias D3 in the third via region 53 and n third conductive vias D2 in the fourth via region 54 are symmetrical about the first axis AA' of the channel signal region to which the n fourth conductive vias and the n third conductive vias belong, and the n second conductive vias D1 in the first via region 51 and the n third conductive vias D2 in the fourth via region 54 are symmetrical about the second axis BB' of the channel signal region to which the n second conductive vias and the n third conductive vias belong;
(3) n third conductive vias D2 in the first via region 51 and n fourth conductive vias D3 in the second via region 52 are symmetrical about the first axis AA' of the channel signal region to which the n third conductive vias and the n fourth conductive vias belong, n first conductive vias D0 in the third via region 53 and n second conductive vias D1 in the fourth via region 54 are symmetrical about the first axis AA' of the channel signal region to which the n first conductive vias and the n second conductive vias belong, and the n third conductive vias D2 in the first via region 51 and the n second conductive vias D1 in the fourth via region 54 are symmetrical about the second axis BB' of the channel signal region to which the n third conductive vias and the n second conductive vias belong; and
(4) n fourth conductive vias D3 in the first via region 51 and n third conductive vias D2 in the second via region 52 are symmetrical about the first axis AA' of the channel signal region to which the n fourth conductive vias and the n third conductive vias belong, n second conductive vias D1 in the third via region 53 and n first conductive vias D0 in the fourth via region 54 are symmetrical about the first axis AA' of the channel signal region to which the n second conductive vias and the n first conductive vias belong, and the n fourth conductive vias D3 in the first via region 51 and the n first conductive vias D0 in the fourth via region 54 are symmetrical about the second axis BB' of the channel signal region to which the n fourth conductive vias and the n first conductive vias belong.

In some embodiments, with reference to FIG. 7A or FIG. 7B, the logic chip 40 further includes (16×m×n) second driver circuits 50. The (16×m×n) second driver circuits 50 are coupled to (16×m×n) conductive vias in a one-to-one correspondence, and the second driver circuits 50 are coupled to parts that are of the conductive vias and that are located on the active surface. The second driver circuits 50 are configured to send signals transmitted by the corresponding conductive vias to an internal circuit of the logic chip 40, or send signals generated by an internal circuit of the logic chip 40 to the corresponding conductive vias.

It should be noted that, for the logic chip 40, all conductive vias in the conductive via groups of the logic chip 40 are connected to the internal circuit of the logic chip 40, to transmit corresponding signals to different memory array parts (different channels) in a chip stacked structure.

In some embodiments, a coordinate position of each conductive via is determined based on the center of the channel signal region to which the conductive via belongs, and types of signals transmitted by four conductive vias with the same coordinate position are the same. The conductive vias are manufactured through any one or more of a via-first process (via-first), a via-middle process (via-middle), a via-last process (via-last), and a back side via-last process (back side via-last); and different conductive vias in the same logic chip are electrically isolated from each other.

In this way, this embodiment of the present disclosure provides a logic chip 40, including multiple channels. Conductive vias in each channel have special symmetry, and can be directly applicable to a face-to-face stacked structure without use of two sets of masks or two sets of vias. Compared with the memory chip in FIG. 2A, parasitic capacitance is reduced as a chip stacked structure formed by the memory chip 10 and the logic chip 40 is used, thereby not only reducing a circuit area, but also reducing chip manufacturing costs. In addition, when the chip stacked structure is formed, a point-to-point direct connection conductive path may be formed, and parasitic resistance may be further reduced compared with the memory chip in FIG. 2B (for a specific reason, refer to the following descriptions).

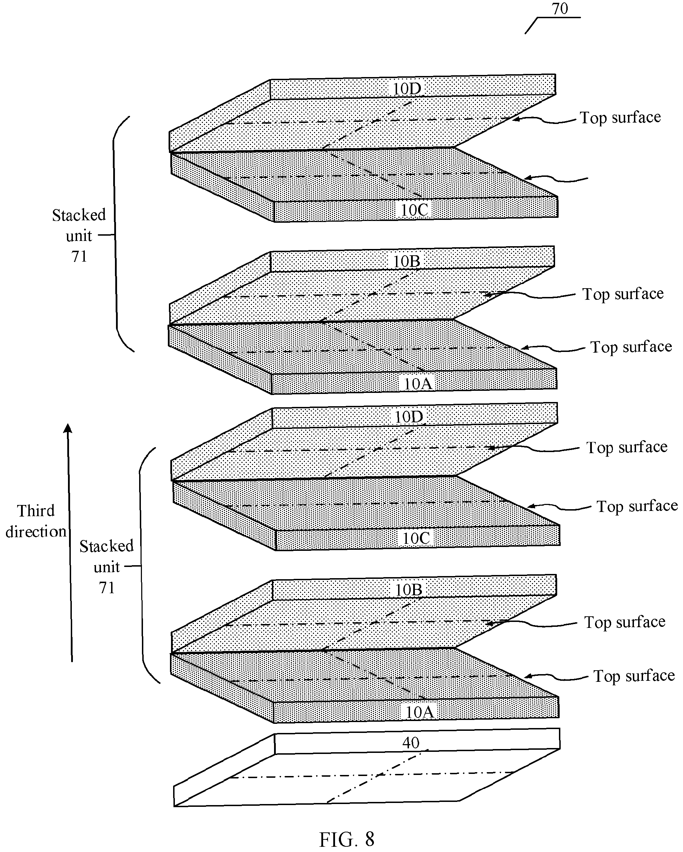

In still another embodiment of the present disclosure, FIG. 8 shows a schematic structural diagram of a chip stacked structure 70 according to an embodiment of the present disclosure. As shown in FIG. 8, the chip stacked structure 70 includes the foregoing logic chip 40 and at least one stacked unit. The logic chip 40 and the at least one stacked unit are sequentially stacked in a third direction. Each stacked unit includes a first memory chip 10A, a second memory chip 10B, a third memory chip 10C, and a fourth memory chip 10D that are sequentially stacked in the third direction. The third direction is perpendicular to an active surface of each memory chip. The first memory chip 10A, the second memory chip 10B, the third memory chip 10C, and the fourth memory chip 10D each are the foregoing memory chip 10. The logic chip 40 and the first memory chip 10A are stacked in a face-to-back manner or in a back-to-back manner. The first memory chip 10A and the second memory chip 10B are stacked in a face-to-face manner. The second memory chip 10B and the third memory chip 10C are stacked in a back-to-back manner. The third memory chip 10C and the fourth memory chip 10D are stacked in a face-to-face manner.

In this embodiment of the present disclosure, face-to-face stacking means that top surfaces of two chips are approximately aligned in the third direction, and center points of the two chips and first axes and second axes of the top surfaces are aligned in the third direction. Back-to-back stacking means that bottom surfaces of two chips are approximately aligned in the third direction. Face-to-back stacking means that a top surface of a chip and a bottom surface of another chip are approximately aligned in the third direction. When no logic chip or memory chip is specified, the "chip" may be either a logic chip or a memory chip.

It should be noted that, in a possible manner, (positions at which conductive vias are aligned in the third direction on) bonding surfaces of two chips connected in a face-to-face manner are electrically connected through hyperbonding (Hyperbonding, also referred to as a bonding pillar); and (positions at which conductive vias are aligned in the third direction on) bonding surfaces of two chips connected in a back-to-back manner or of two chips connected in a face-to-back manner are electrically connected through a conductive bump (UBump, also referred to as a micro-bump).

In another possible manner, (positions at which conductive vias are aligned in the third direction on) bonding surfaces of the chips connected in a face-to-face manner, of two chips connected in a back-to-back manner, or of two chips connected in a face-to-back manner, are connected through a hybrid bonding structure. To be specific, (the positions at which conductive vias are aligned in the third direction on) the bonding surfaces of the two chips connected in a face-to-face manner are electrically connected through a hybrid bonding structure, and (the positions at which conductive vias are aligned in the third direction on) the bonding surfaces of the two chips connected in a back-to-back manner and (the positions at which conductive vias are aligned in the third direction on) the bonding surfaces of the two chips connected in a face-to-back manner are also electrically connected through a hybrid bonding structure.

In still another possible manner, (positions at which conductive vias are aligned in the third direction on) bonding surfaces of two chips connected in a face-to-face manner or of two chips connected in a back-to-back manner or in a face-to-back manner are connected through a conductive bump. To be specific, (the positions at which conductive vias are aligned in the third direction on) the bonding surfaces of the two chips connected in a face-to-face manner are connected through a conductive bump, and (the positions at which conductive vias are aligned in the third direction on) the bonding surfaces of the two chips connected in a back-to-back manner and (the positions at which conductive vias are aligned in the third direction on) the bonding surfaces of the two chips connected in a face-to-back manner are also connected through a conductive bump.

Herein, the foregoing chip may refer to the logic chip 40, or may refer to the memory chip 10.

It should be noted that, compared with a conductive bump process, a face-to-face connection implemented through a hybrid bonding process can make adjacent chips attached more closely, and there is basically no gap, thereby greatly reducing the height of the chip stacked structure. This is also one of advantages of face-to-face stacking. Certainly, the two chips connected in a back-to-back manner may also be connected through a hybrid bonding structure, but connection performance of the two chips connected through the hybrid bonding structure is less than that of the two chips connected through a conductive bump process.

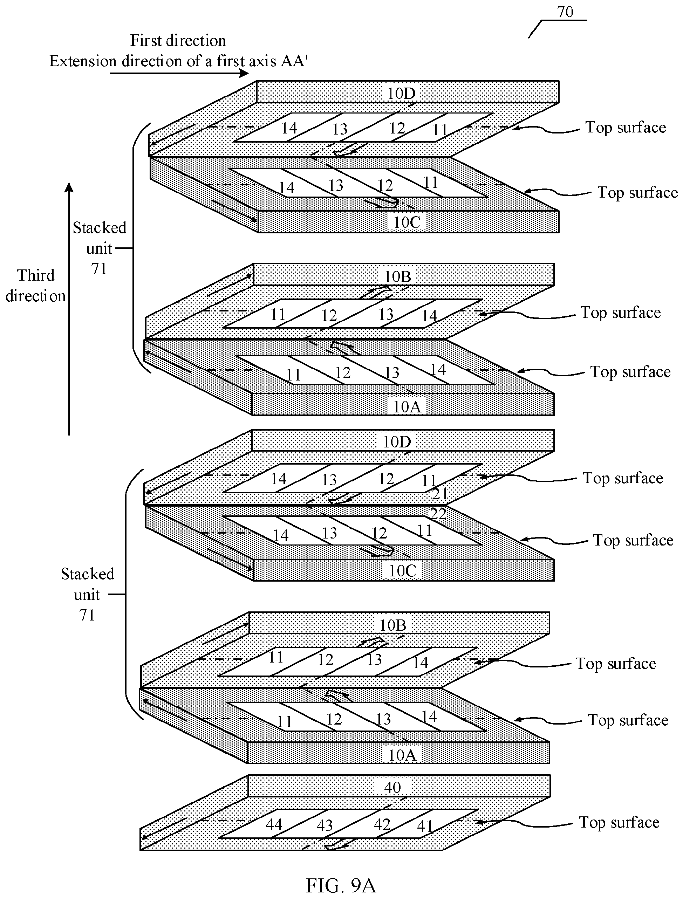

It should be noted that the logic chip 40 or the memory chip may be divided into an upper transmission region and a lower transmission region. All arrows in subsequent FIG. 9A to FIG. 12B are located in upper transmission regions of chips. In particular, in this embodiment of the present disclosure, the upper transmission region and the lower transmission region are only two regions for distinguishing a memory chip, do not have additional other limitations, and are not related to most significant bit data and least significant bit data commonly known in data transmission.

It should be further noted that, with reference to FIG. 9A, the logic chip 40 includes m channel signal regions arranged in a first direction, each memory chip has m channels arranged in the first direction (an example in which m=4 is illustrated), and each channel includes a first memory array region, a channel signal region, and a second memory array region that are sequentially distributed in a second direction.

When the logic chip 40 and the first memory chip 10A are stacked in a back-to-back manner, and respective first axes AA' of the logic chip 40 and each memory chip each extend in the first direction (that is, the first axis AA' divides the chip to which the first axis belongs into an upper transmission region and a lower transmission region), an upper transmission region of the logic chip 40, an upper transmission region of the first memory chip 10A, a lower transmission region of the second memory chip 10B, a lower transmission region of the third memory chip 10C, and an upper transmission region of the fourth memory chip 10D are aligned in a third direction; and a lower transmission region of the logic chip 40, a lower transmission region of the first memory chip 10A, an upper transmission region of the second memory chip 10B, an upper transmission region of the third memory chip 10C, and a lower transmission region of the fourth memory chip 10D are aligned in the third direction.

Specifically, the channel signal regions of the chips have the following symmetrical relationship: The (m-i)th channel signal region in the logic chip 40 is aligned with the channel signal region in the (i+1)th channel in the first memory chip 10A, the channel signal region in the (i+1)th channel in the second memory chip 10B, the channel signal region in the (m-i)th channel in the third memory chip 10C, and the channel signal region in the (m-i)th channel in the fourth memory chip 10D in the third direction, where i is a natural number less than m.

FIG. 9A illustrates an example in which m=4. In this case:
(1) the fourth channel signal region 44 in the logic chip 40 is aligned with the channel signal region 11 in the first channel in the first memory chip 10A in the third direction, the channel signal region 11 in the first channel in the second memory chip 10B in the third direction, the channel signal region 14 in the fourth channel in the third memory chip 10C in the third direction, and the channel signal region 14 in the fourth channel in the fourth memory chip 10D in the third direction;
(2) the third channel signal region 43 in the logic chip 40 is aligned with the channel signal region 12 in the second channel in the first memory chip 10A in the third direction, the channel signal region 12 in the second channel in the second memory chip 10B in the third direction, the channel signal region 13 in the third channel in the third memory chip 10C in the third direction, and the channel signal region 13 in the third channel in the fourth memory chip 10D in the third direction;
(3) the second channel signal region 42 in the logic chip 40 is aligned with the channel signal region 13 in the third channel in the first memory chip 10A in the third direction, the channel signal region 13 in the third channel in the second memory chip 10B in the third direction, the channel signal region 12 in the second channel in the third memory chip 10C in the third direction, and the channel signal region 12 in the second channel in the fourth memory chip 10D in the third direction; and
(4) the first channel signal region 41 in the logic chip 40 is aligned with the channel signal region 14 in the fourth channel in the first memory chip 10A in the third direction, the channel signal region 14 in the fourth channel in the second memory chip 10B in the third direction, the channel signal region 11 in the first channel in the third memory chip 10C in the third direction, and the channel signal region 11 in the first channel in the fourth memory chip 10D in the third direction.

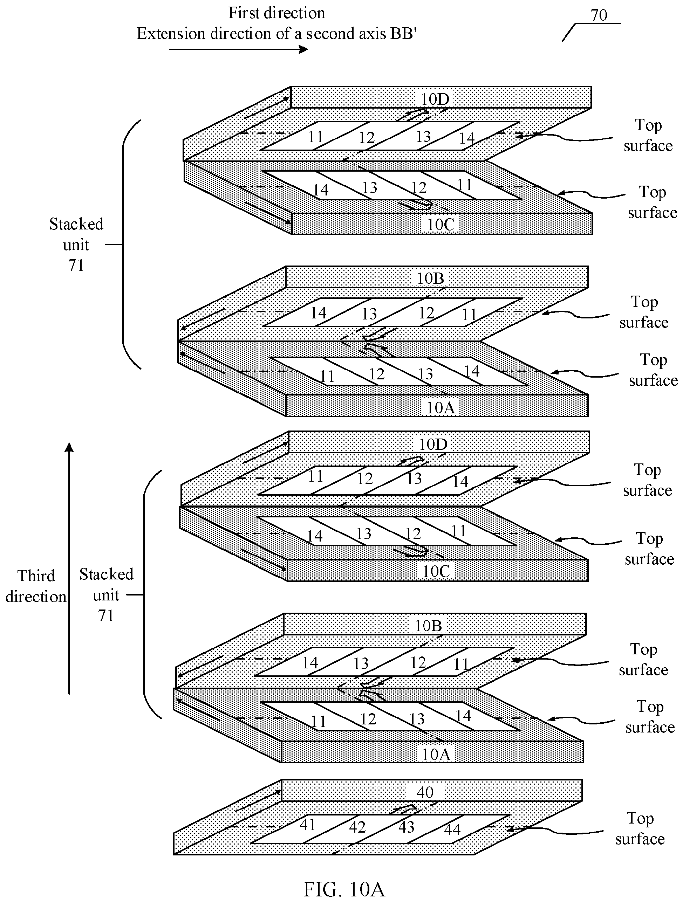

In some other embodiments, with reference to FIG. 10A (an example in which m=4 is illustrated), when the logic chip 40 and the first memory chip 10A are stacked in a back-to-back manner, and respective second axes BB' of the logic chip 40 and each memory chip each extend in the first direction (that is, the second axis BB' divides the chip to which the second axis belongs into an upper transmission region and a lower transmission region), a lower transmission region of the logic chip 40, an upper transmission region of the first memory chip 10A, an upper transmission region of the second memory chip 10B, a lower transmission region of the third memory chip 10C, and a lower transmission region of the fourth memory chip 10D are aligned in the third direction; and an upper transmission region of the logic chip 40, a lower transmission region of the first memory chip 10A, a lower transmission region of the second memory chip 10B, an upper transmission region of the third memory chip 10C, and an upper transmission region of the fourth memory chip 10D are aligned in the third direction.

Specifically, the channel signal regions of the chips have the following symmetrical relationship: The (i+1)th channel signal region in the logic chip 40 is aligned with the channel signal region in the (i+1)th channel in the first memory chip 10A, the channel signal region in the (m-i)th channel in the second memory chip 10B, the channel signal region in the (m-i)th channel in the third memory chip 10C, and the channel signal region in the (i+1)th channel in the fourth memory chip 10D in the third direction, where i is a natural number less than m.

FIG. 10A illustrates an example in which m=4. In this case:
(1) the first channel signal region 41 in the logic chip 40, the channel signal region 11 in the first channel in the first memory chip 10A, the channel signal region 14 in the fourth channel in the second memory chip 10B, the channel signal region 14 in the fourth channel in the third memory chip 10C, and the channel signal region 11 in the first channel in the fourth memory chip 10D are aligned in the third direction;
(2) the second channel signal region 42 in the logic chip 40, the channel signal region 12 in the second channel in the first memory chip 10A, the channel signal region 13 in the third channel in the second memory chip 10B, the channel signal region 13 in the third channel in the third memory chip 10C, and the channel signal region 12 in the second channel in the fourth memory chip 10D are aligned in the third direction;
(3) the third channel signal region 43 in the logic chip 40, the channel signal region 13 in the third channel in the first memory chip 10A, the channel signal region 12 in the second channel in the second memory chip 10B, the channel signal region 12 in the second channel in the third memory chip 10C, and the channel signal region 13 in the third channel in the fourth memory chip 10D are aligned in the third direction; and
(4) the fourth channel signal region 44 in the logic chip 40, the channel signal region 14 in the fourth channel in the first memory chip 10A, the channel signal region 11 in the first channel in the second memory chip 10B, the channel signal region 11 in the first channel in the third memory chip 10C, and the channel signal region 14 in the fourth channel in the fourth memory chip 10D are aligned in the third direction.

Briefly, for FIG. 9A to FIG. 10B, the logic chip 40 and the fourth memory chip 10D are disposed in the same manner.

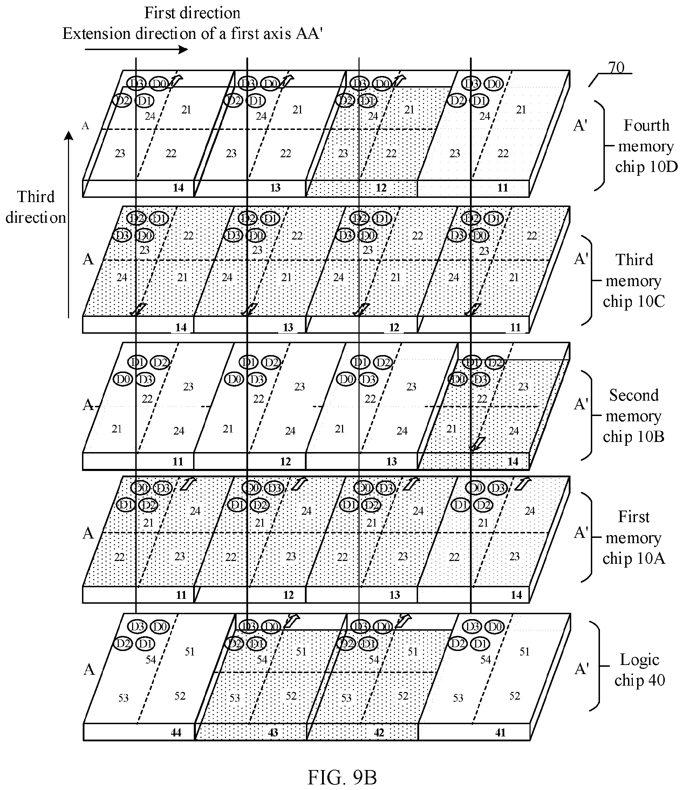

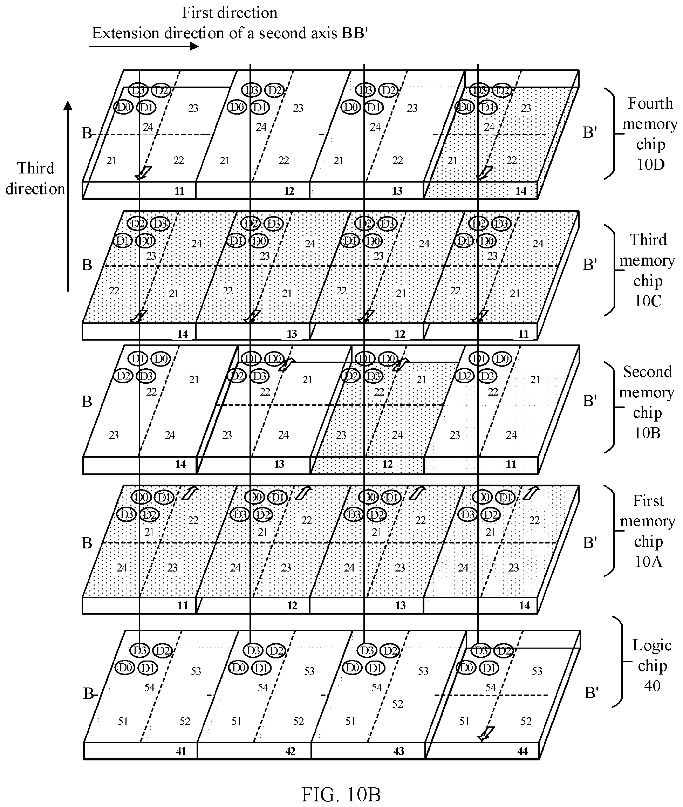

It should be further noted that, regardless of FIG. 9B or FIG. 10B, the channel signal region in each channel of the memory chip and the logic chip is divided into 2×2 via regions distributed in an array. Refer to FIG. 9A or FIG. 9B. The multiple channel signal regions aligned in the third direction have the following characteristics:
(1) a fourth via region 54 belonging to the logic chip 40, a first via region 21 belonging to the first memory chip 10A, a second via region 22 belonging to the second memory chip 10B, a third via region 23 belonging to the third memory chip 10C, and a fourth via region 24 belonging to the fourth memory chip 10D are aligned in the third direction;
(2) a third via region 53 belonging to the logic chip 40, a second via region 22 belonging to the first memory chip 10A, a first via region 21 belonging to the second memory chip 10B, a fourth via region 24 belonging to the third memory chip 10C, and a third via region 23 belonging to the fourth memory chip 10D are aligned in the third direction;
(3) a second via region 52 belonging to the logic chip 40, a third via region 23 belonging to the first memory chip 10A, a fourth via region 24 belonging to the second memory chip 10B, a first via region 21 belonging to the third memory chip 10C, and a second via region 22 belonging to the fourth memory chip 10D are aligned in the third direction; and
(4) a first via region 51 belonging to the logic chip 40, a fourth via region 24 belonging to the first memory chip 10A, a third via region 23 belonging to the second memory chip 10B, a second via region 22 belonging to the third memory chip 10C, and a first via region 21 belonging to the fourth memory chip 10D are aligned in the third direction.

In some embodiments, when each conductive via group includes a first conductive via, a second conductive via, a third conductive via, and a fourth conductive via that are distributed in a 2×2 array, with reference to FIG. 9B or FIG. 10B, each via region of the memory chip and the logic chip 40 includes n conductive via groups with the same distribution position, each conductive via group has a third axis CC' and a fourth axis DD', the third axis CC' is parallel to the first axis AA', and the fourth axis DD' and the third axis CC' are perpendicular to each other and intersect at the center of the conductive via group to which they belong. The first conductive via D0 and the second conductive via D1 are symmetrical about the third axis CC' of the conductive via group to which the first conductive via and the second conductive via belong, the third conductive via D2 and the fourth conductive via D3 are symmetrical about the third axis CC' of the conductive via group to which the third conductive via and the fourth conductive via belong, and the first conductive via D0 and the fourth conductive via D3 are symmetrical about the fourth axis DD' of the conductive via group to which the first conductive via and the fourth conductive via belong.

For the multiple via regions aligned in the third direction:
(1) the fourth conductive via D3 belonging to the logic chip 40, the first conductive via D0 belonging to the first memory chip 10A, the second conductive via D1 belonging to the second memory chip 10B, the third conductive via D2 belonging to the third memory chip 10C, and the fourth conductive via D3 belonging to the fourth memory chip 10D are aligned in the third direction;
(2) the third conductive via D2 belonging to the logic chip 40, the second conductive via D1 belonging to the first memory chip 10A, the first conductive via D0 belonging to the second memory chip 10B, the fourth conductive via D3 belonging to the third memory chip 10C, and the third conductive via D2 belonging to the fourth memory chip 10D are aligned in the third direction;
(3) the second conductive via D1 belonging to the logic chip 40, the third conductive via D2 belonging to the first memory chip 10A, the fourth conductive via D3 belonging to the second memory chip 10B, the first conductive via D0 belonging to the third memory chip 10C, and the second conductive via D1 belonging to the fourth memory chip 10D are aligned in the third direction; and
(4) the first conductive via D0 belonging to the logic chip 40, the fourth conductive via D3 belonging to the first memory chip 10A, the third conductive via D2 belonging to the second memory chip 10B, the second conductive via D1 belonging to the third memory chip 10C, and the first conductive via D0 belonging to the fourth memory chip 10D are aligned in the third direction. The multiple conductive vias aligned in the third direction are coupled to form a conductive channel.

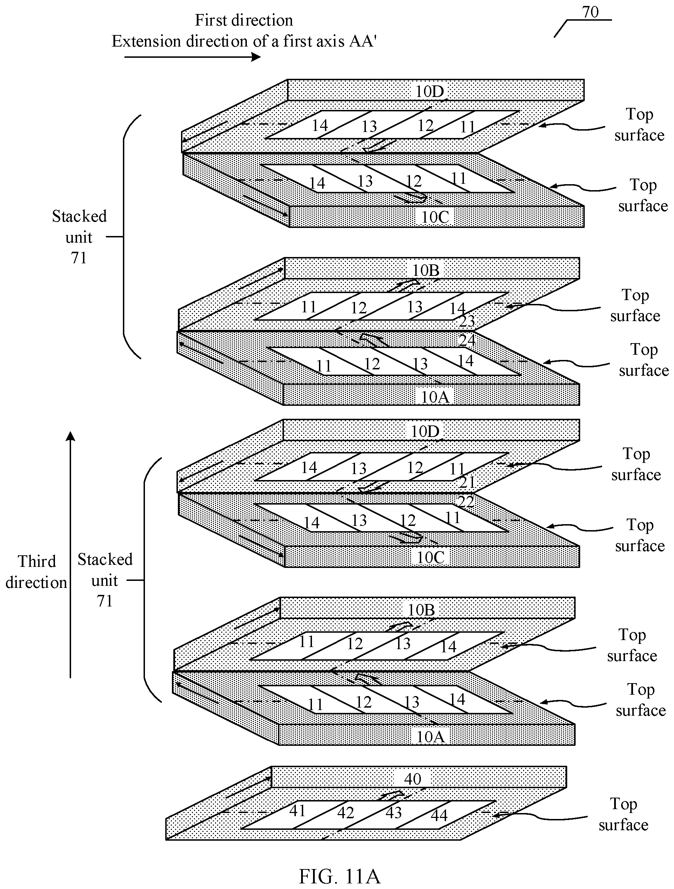

In some other embodiments, with reference to FIG. 11A (an example in which m=4 is illustrated), when the logic chip 40 and the first memory chip 10A are stacked in a back-to-back manner, and respective first axes AA' of the logic chip 40 and each memory chip each extend in the first direction (that is, the first axis AA' divides the chip to which the first axis belongs into an upper transmission region and a lower transmission region), a lower transmission region of the logic chip 40, an upper transmission region of the first memory chip 10A, a lower transmission region of the second memory chip 10B, a lower transmission region of the third memory chip 10C, and an upper transmission region of the fourth memory chip 10D are aligned in the third direction; and an upper transmission region of the logic chip 40, a lower transmission region of the first memory chip 10A, an upper transmission region of the second memory chip 10B, an upper transmission region of the third memory chip 10C, and a lower transmission region of the fourth memory chip 10D are aligned in the third direction.

Specifically, the channel signal regions of the chips have the following symmetrical relationship: The (i+1)th channel signal region in the logic chip 40 is aligned with the channel signal region in the (i+1)th channel in the first memory chip 10A, the channel signal region in the (i+1)th channel in the second memory chip 10B, the channel signal region in the (m-i)th channel in the third memory chip 10C, and the channel signal region in the (m-i)th channel in the fourth memory chip 10D in the third direction, where i is a natural number less than m.

FIG. 11A illustrates an example in which m=4. In this case:
(1) the first channel signal region 41 in the logic chip 40, the channel signal region 11 in the first channel in the first memory chip 10A, the channel signal region 11 in the first channel in the second memory chip 10B, the channel signal region 14 in the fourth channel in the third memory chip 10C, and the channel signal region 14 in the fourth channel in the fourth memory chip 10D are aligned in the third direction;
(2) the second channel signal region 42 in the logic chip 40, the channel signal region 12 in the second channel in the first memory chip 10A, the channel signal region 12 in the second channel in the second memory chip 10B, the channel signal region 13 in the third channel in the third memory chip 10C, and the channel signal region 13 in the third channel in the fourth memory chip 10D are aligned in the third direction;
(3) the third channel signal region 43 in the logic chip 40, the channel signal region 13 in the third channel in the first memory chip 10A, the channel signal region 13 in the third channel in the second memory chip 10B, the channel signal region 12 in the second channel in the third memory chip 10C, and the channel signal region 12 in the second channel in the fourth memory chip 10D are aligned in the third direction; and
(4) the fourth channel signal region 44 in the logic chip 40, the channel signal region 14 in the fourth channel in the first memory chip 10A, the channel signal region 14 in the fourth channel in the second memory chip 10B, the channel signal region 11 in the first channel in the third memory chip 10C, and the channel signal region 11 in the first channel in the fourth memory chip 10D are aligned in the third direction.

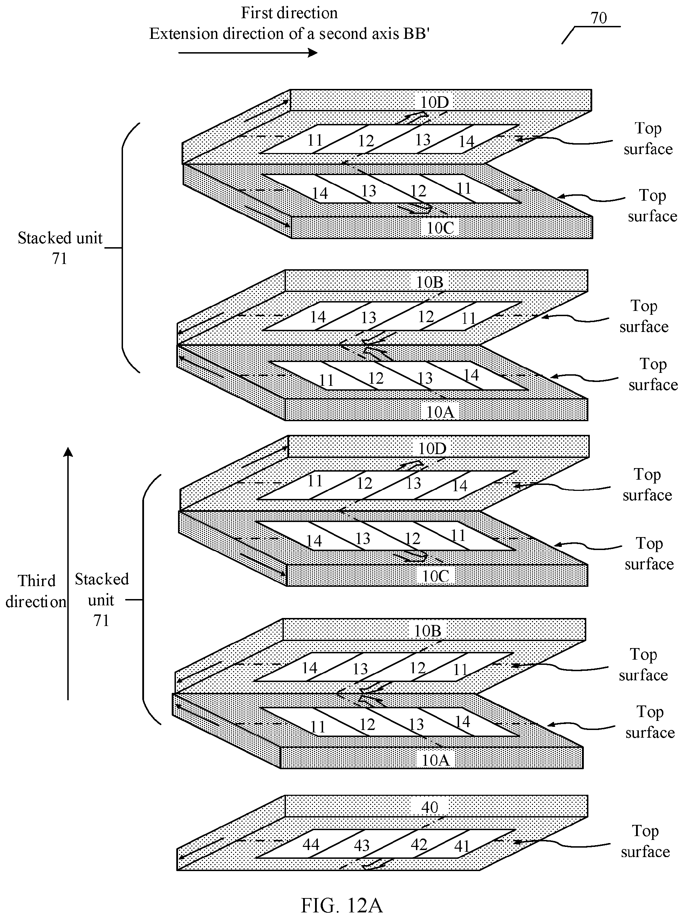

In some other embodiments, with reference to FIG. 12A (an example in which m=4 is illustrated), when m=4, the logic chip 40 and the first memory chip 10A are stacked in a back-to-back manner, and respective second axes BB' of the logic chip 40 and each memory chip each extend in the first direction (that is, the second axis BB' divides the chip to which the second axis belongs into an upper transmission region and a lower transmission region), an upper transmission region of the logic chip 40, an upper transmission region of the first memory chip 10A, an upper transmission region of the second memory chip 10B, a lower transmission region of the third memory chip 10C, and a lower transmission region of the fourth memory chip 10D are aligned in the third direction; and a lower transmission region of the logic chip 40, a lower transmission region of the first memory chip 10A, a lower transmission region of the second memory chip 10B, an upper transmission region of the third memory chip 10C, and an upper transmission region of the fourth memory chip 10D are aligned in the third direction.

Specifically, the channel signal regions of the chips have the following symmetrical relationship: The (m-i)th channel signal region in the logic chip 40 is aligned with the channel signal region in the (i+1)th channel in the first memory chip 10A, the channel signal region in the (m-i)th channel in the second memory chip 10B, the channel signal region in the (m-i)th channel in the third memory chip 10C, and the channel signal region in the (i+1)th channel in the fourth memory chip 10D in the third direction, where i is a natural number less than m.
(1) The fourth channel signal region 44 in the logic chip 40, the channel signal region 11 in the first channel in the first memory chip 10A, the channel signal region 14 in the fourth channel in the second memory chip 10B, the channel signal region 14 in the fourth channel in the third memory chip 10C, and the channel signal region 11 in the first channel in the fourth memory chip 10D are aligned in the third direction.
(2) The third channel signal region 43 in the logic chip 40, the channel signal region 12 in the second channel in the first memory chip 10A, the channel signal region 13 in the third channel in the second memory chip 10B, the channel signal region 13 in the third channel in the third memory chip 10C, and the channel signal region 12 in the second channel in the fourth memory chip 10D are aligned in the third direction.
(3) The second channel signal region 42 in the logic chip 40, the channel signal region 13 in the third channel in the first memory chip 10A, the channel signal region 12 in the second channel in the second memory chip 10B, the channel signal region 12 in the second channel in the third memory chip 10C, and the channel signal region 13 in the third channel in the fourth memory chip 10D are aligned in the third direction.
(4) The first channel signal region 41 in the logic chip 40, the channel signal region 14 in the fourth channel in the first memory chip 10A, the channel signal region 11 in the first channel in the second memory chip 10B, the channel signal region 11 in the first channel in the third memory chip 10C, and the channel signal region 14 in the fourth channel in the fourth memory chip 10D are aligned in the third direction.

Briefly, for FIG. 11A to FIG. 12B, the logic chip 40 and the second memory chip 10B are disposed in the same manner.

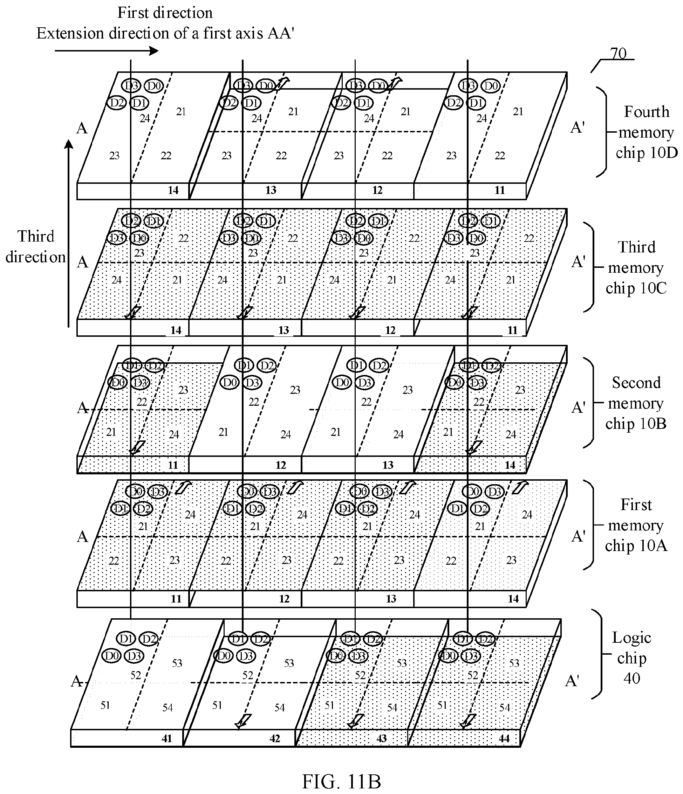

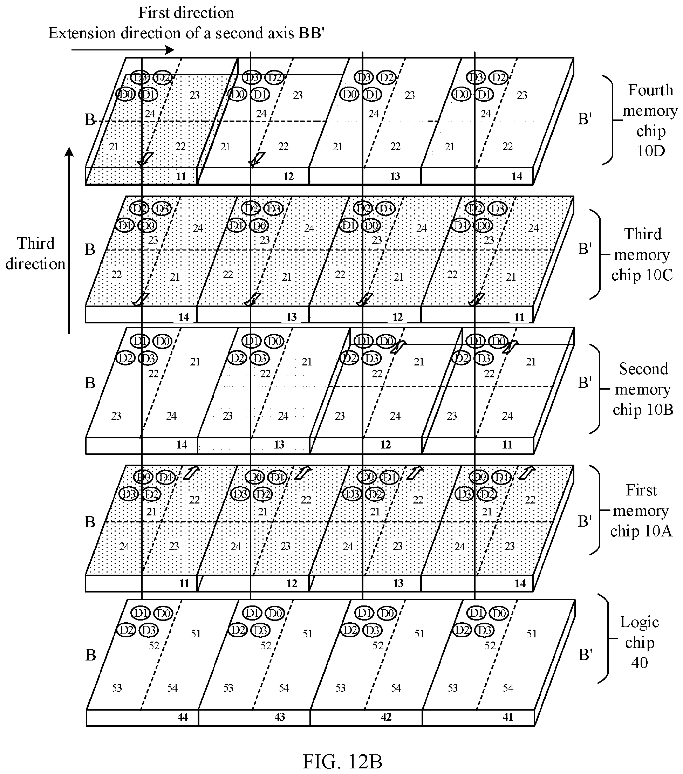

In some embodiments, with reference to FIG. 11B and FIG. 12B, the channel signal region in each channel of the memory chip and the logic chip 40 is divided into 2×2 via regions distributed in an array. Refer to FIG. 11B and FIG. 12B. For the multiple channel signal regions aligned in the third direction:
(1) a second via region 52 belonging to the logic chip 40, a first via region 21 belonging to the first memory chip 10A, a second via region 22 belonging to the second memory chip 10B, a third via region 23 belonging to the third memory chip 10C, and a fourth via region 24 belonging to the fourth memory chip 10D are aligned in the third direction;
(2) a first via region 51 belonging to the logic chip 40, a second via region 22 belonging to the first memory chip 10A, a first via region 21 belonging to the second memory chip 10B, a fourth via region 24 belonging to the third memory chip 10C, and a third via region 23 belonging to the fourth memory chip 10D are aligned in the third direction;
(3) a fourth via region 54 belonging to the logic chip 40, a third via region 23 belonging to the first memory chip 10A, a fourth via region 24 belonging to the second memory chip 10B, a first via region 21 belonging to the third memory chip 10C, and a second via region 22 belonging to the fourth memory chip 10D are aligned in the third direction; and
(4) a third via region 53 belonging to the logic chip 40, a fourth via region 24 belonging to the first memory chip 10A, a third via region 23 belonging to the second memory chip 10B, a second via region 22 belonging to the third memory chip 10C, and a first via region 21 belonging to the fourth memory chip 10D are aligned in the third direction.

Refer to FIG. 11B or FIG. 12B. When each conductive via group includes a first conductive via, a second conductive via, a third conductive via, and a fourth conductive via that are distributed in a 2×2 array, with reference to FIG. 11B or FIG. 12B, each via region of the memory chip and the logic chip 40 includes n conductive via groups with the same distribution position, each conductive via group has a third axis CC' and a fourth axis DD', the third axis CC' is parallel to the first axis AA', and the fourth axis DD' and the third axis CC' are perpendicular to each other and intersect at the center of the conductive via group to which they belong. The first conductive via D0 and the second conductive via D1 are symmetrical about the third axis CC' of the conductive via group to which the first conductive via and the second conductive via belong, the third conductive via D2 and the fourth conductive via D3 are symmetrical about the third axis CC' of the conductive via group to which the third conductive via and the fourth conductive via belong, and the first conductive via D0 and the fourth conductive via D3 are symmetrical about the fourth axis DD' of the conductive via group to which the first conductive via and the fourth conductive via belong.

For the multiple via regions aligned in the third direction:
(1) the second conductive via D1 belonging to the logic chip 40, the first conductive via D0 belonging to the first memory chip 10A, the second conductive via D1 belonging to the second memory chip 10B, the third conductive via D2 belonging to the third memory chip 10C, and the fourth conductive via D3 belonging to the fourth memory chip 10D are aligned in the third direction;
(2) the first conductive via D0 belonging to the logic chip 40, the second conductive via D1 belonging to the first memory chip 10A, the first conductive via D0 belonging to the second memory chip 10B, the fourth conductive via D3 belonging to the third memory chip 10C, and the third conductive via D2 belonging to the fourth memory chip 10D are aligned in the third direction;
(3) the fourth conductive via D3 belonging to the logic chip 40, the third conductive via D2 belonging to the first memory chip 10A, the fourth conductive via D3 belonging to the second memory chip 10B, the first conductive via D0 belonging to the third memory chip 10C, and the second conductive via D1 belonging to the fourth memory chip 10D are aligned in the third direction; and
(4) the third conductive via D2 belonging to the logic chip 40, the fourth conductive via D3 belonging to the first memory chip 10A, the third conductive via D2 belonging to the second memory chip 10B, the second conductive via D1 belonging to the third memory chip 10C, and the first conductive via D0 belonging to the fourth memory chip 10D are aligned in the third direction.

The multiple conductive vias aligned in the third direction are coupled to form a conductive channel.

It can be learned from the foregoing that, for the embodiments shown by FIG. 9A to FIG. 12B, the multiple conductive vias aligned in the third direction respectively include the first conductive via D0, the second conductive via D1, the third conductive via D2, and the fourth conductive via D3, so that the rotatable connection in FIG. 2B is implemented through a direct connection configuration similar to that in FIG. 2A. A formed chip stacked structure not only has relatively low parasitic resistance but also has relatively low parasitic capacitance, and can implement face-to-face stacking.

The stacking manners shown in FIG. 9A and FIG. 9B are only used as an example to describe a signal transmission principle. In another case, adaptive understanding is required.

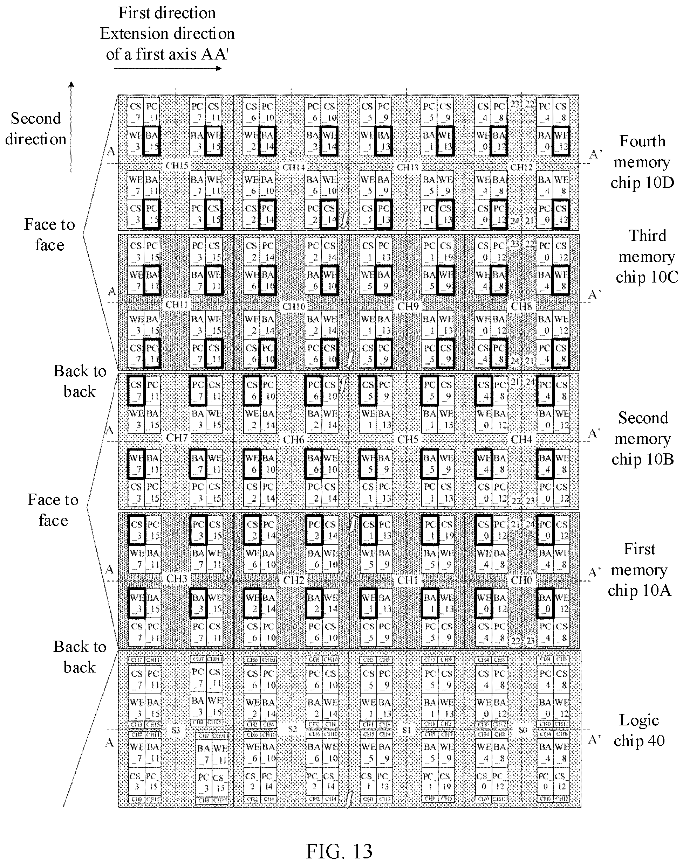

As shown in FIG. 9A and FIG. 9B, the example in which m=4 is used for description. Each memory chip includes four channels, and each stacked unit includes 16 channels, corresponding to 16 channel signal regions. FIG. 13 shows a schematic diagram of signal transmission of all chips in a chip stacked structure. In particular, FIG. 13 shows top surfaces of all chips. As shown in FIG. 13, the fourth channel signal region to the first channel signal region in the logic chip 40 are sequentially referred to as S0, S1, S2, and S3. Four channel signal regions sequentially corresponding to the fourth channel to the first channel in the first memory chip 10A are referred to as CH0, CH1, CH2, and CH3. Four channel signal regions sequentially corresponding to the fourth channel to the first channel in the second memory chip 10B are referred to as CH4, CH5, CH6, and CH7. Four channel signal regions sequentially corresponding to the first channel to the fourth channel in the third memory chip 10C are referred to as CH8, CH9, CH10, and CH11. Four channel signal regions sequentially corresponding to the first channel to the fourth channel in the fourth memory chip 10D are referred to as CH12, CH13, CH14, and CH15. The 16 channels have respective control signals. FIG. 13 illustrates transmission of four types of control signals: chip select signals (CS_0 to CS_15), virtual channel signals (PC_0 to PC_15), write enable signals (WE_0 to WE_15), and bank address signals (BA_0 to BA_15). Certainly, there are still many types of control signals, such as a command address signal CA, a bank group signal BG, and a read enable signal. The following only uses CS_0 to CS_15 as an example for specific description.

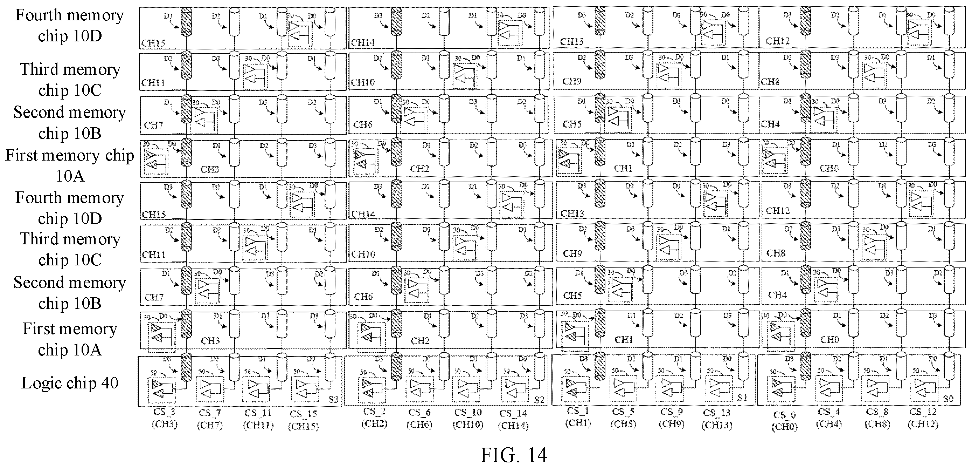

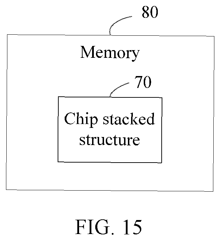

Refer to FIG. 14 and FIG. 15. Four conductive vias that are in each channel of the logic chip 40 and are symmetrical about a first axis and a second axis are configured to transmit chip select signals. The channel S0 in the logic chip 40 is used as an example. The fourth via D3 (in the fourth via region) in S0 is configured to transmit CS_0, the third via D2 (in the third via region) in S0 is configured to transmit CS_4, the second via D1 (in the second via region) in S0 is configured to transmit CS_8, and the first via D0 (in the first via region) in S0 is configured to transmit CS_12.

For CS_0, it is transmitted upward sequentially through the fourth via D3 (in the fourth via region of the channel S0) of the logic chip 40, the first via D0 (in the first via region 21 of the channel CH0) of the first memory chip 10A, the second via D1 (in the second via region 22 of the channel CH4) of the second memory chip 10B, the third via D2 (in the third via region 23 of the channel CH8) of the third memory chip 10C, the fourth via D3 (in the fourth via region 24 of the channel CH12) of the fourth memory chip 10D, and so on. On this transmission route, CS_0 enters the channel CH0 of the first memory chip 10A in each stacked unit through the first via D0 in the transmission route, to control a corresponding part. However, because the second via D1, the third via D2, and the fourth via D3 do not have a driver circuit, they are electrically isolated from an internal circuit of the chip to which they belong. Therefore, CS_0 does not enter the second memory chip 10B, the third memory chip 10C, or the fourth memory chip 10D.

Similarly, for CS_4, it is transmitted upward sequentially through the third via D2 (in the third via region of the channel S0) of the logic chip 40, the second via D1 (in the second via region of the channel CH0) of the first memory chip 10A, the first via D0 (in the first via region of the channel CH4) of the second memory chip 10B, the fourth via D3 (in the fourth via region of the channel CH8) of the third memory chip 10C, the third via D2 (in the third via region of the channel CH12) of the fourth memory chip 10D, and so on. On this transmission route, CS_4 enters the channel CH4 of the second memory chip 10B in each stacked unit through the corresponding first via D0, to control a corresponding part. However, because the second via D1, the third via D2, and the fourth via D3 do not have a driver circuit, they are electrically isolated from an internal circuit of the chip to which they belong. Therefore, CS_4 does not enter the first memory chip 10A, the third memory chip 10C, or the fourth memory chip 10D.

The rest can be understood by reference.

In this way, for the chip stacked structure 70, from a physical perspective, the conductive vias in the chip stacked structure are still in a direct connection configuration. However, from a perspective of absolute positions of the conductive vias on an active surface, the conductive vias in the chip stacked structure may be considered as a functional rotatable configuration, that is, a signal transmission effect similar to that in FIG. 2B (i.e., a rotatable transmission effect implemented through the via D0 - the via D1 - the via D2 - the via D3 ...) is implemented through a physical direct connection configuration. Briefly, the chip stacked structure 70 in FIG. 2B requires a physical spiral structure, and a horizontal interconnection structure necessarily exists. The chip stacked structure 70 in FIG. 14 is physically a direct connection structure, without requiring a horizontal interconnection structure, so that parasitic resistance is greatly reduced, and a transmission speed and transmission performance are greatly improved.

In yet another embodiment of the present disclosure, FIG. 15 shows a schematic structural diagram of a memory 80 according to an embodiment of the present disclosure. As shown in FIG. 15, the memory 80 includes at least the foregoing chip stacked structure 70. The memory 80 may be a static random access memory (SRAM), a dynamic random access memory (DRAM), a synchronous dynamic random access memory (SDRAM), a double data rate synchronous dynamic random access memory (DDR SDRAM), or the like. This is not specifically limited herein.

The foregoing embodiments are merely preferred embodiments of the present disclosure, and are not intended to limit the protection scope of the present disclosure. It should be noted that in the present disclosure, the terms "include", "comprise", or any other variant thereof are intended to cover non-exclusive inclusion, so that a procedure, method, article, or apparatus that includes a series of elements includes not only those elements but also other elements that are not expressly listed, or further includes elements inherent to such a procedure, method, article, or apparatus. An element preceded by "includes a ..." does not, without more constraints, preclude the presence of additional identical elements in the procedure, method, article, or apparatus that includes the element. The sequence numbers of the foregoing embodiments of the present disclosure are merely for the purpose of description, and are not intended to indicate priorities of the embodiments. The methods disclosed in the several method embodiments provided in the present disclosure may be randomly combined when there is no conflict, to obtain new method embodiments. The features disclosed in the several product embodiments provided in the present disclosure may be randomly combined when there is no conflict, to obtain new product embodiments. The features disclosed in the several method or device embodiments provided in the present disclosure may be randomly combined when there is no conflict, to obtain new method embodiments or new device embodiments. The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of this disclosure shall be subject to the protection scope of the claims.

## Claims

1. A memory chip (10), wherein the memory chip (10) comprises m channels, the m channels are sequentially arranged in a first direction, the memory chip (10) has a chip axis extending in a second direction and passing through a center of the memory chip (10), and the m channels are symmetrical about the chip axis; each of the channels comprises a first memory array region, a channel signal region (11, 12, 13, 14), and a second memory array region that are sequentially distributed in the second direction, a center of each channel signal region (11, 12, 13, 14) coincides with a center of the channel to which the channel signal region belongs, and m is a positive integer; the first direction is perpendicular to the second direction;
each channel signal region (11, 12, 13, 14) has a first axis and a second axis, the first axis extends in the first direction or the second direction, and the second axis and the first axis are perpendicular to each other and intersect at the center of the channel signal region (11, 12, 13, 14) to which the first axis and the second axis belong; each channel signal region (11, 12, 13, 14) is divided into 2×2 via regions distributed in an array, a first via region (21) and a second via region (22) are symmetrical along the first axis of the channel signal region (11, 12, 13, 14) to which the first via region and the second via region belong, a third via region (23) and a fourth via region (24) are symmetrical along the first axis of the channel signal region (11, 12, 13, 14) to which the third via region and the fourth via region belong, and the first via region (21) and the fourth via region (24) are symmetrical along the second axis of the channel signal region (11, 12, 13, 14) to which the first via region and the fourth via region belong;
each of the via regions includes n conductive via groups, the n conductive via groups penetrate through a substrate of the memory chip (10) in a direction perpendicular to an active surface of the memory chip (10), and n is a natural number; areas of m channel signal regions (11, 12, 13, 14) are the same, and distribution positions of the conductive via groups in the m channel signal regions (11, 12, 13, 14) are the same; and
in a same channel signal region (11, 12, 13, 14), n conductive via groups in the first via region (21) and n conductive via groups in the second via region (22) are symmetrical about the first axis of the channel signal region (11, 12, 13, 14) to which the conductive via groups belong, n conductive via groups in the third via region (23) and n conductive via groups in the fourth via region (24) are symmetrical about the first axis of the channel signal region (11, 12, 13, 14) to which the conductive via groups belong, and the n conductive via groups in the first via region (21) and the n conductive via groups in the fourth via region (24) are symmetrical about the second axis of the channel signal region (11, 12, 13, 14) to which the conductive via groups belong.

2. The memory chip (10) according to claim 1, wherein
each of the conductive via groups has a third axis and a fourth axis, the third axis is parallel to the first axis, and the fourth axis and the third axis are perpendicular to each other and intersect at a center of the conductive via group to which the third axis and the fourth axis belong;
when each of the conductive via groups comprises a first conductive via, a second conductive via, a third conductive via, and a fourth conductive via that are distributed in a 2×2 array, the first conductive via and the second conductive via are symmetrical about the third axis of the conductive via group to which the first conductive via and the second conductive via belong, the third conductive via and the fourth conductive via are symmetrical about the third axis of the conductive via group to which the third conductive via and the fourth conductive via belong, and the first conductive via and the fourth conductive via are symmetrical about the fourth axis of the conductive via group to which the first conductive via and the fourth conductive via belong;
in each channel signal region (11, 12, 13, 14), n first conductive vias in the first via region (21) and n second conductive vias in the second via region (22) are symmetrical about the first axis of the channel signal region (11, 12, 13, 14) to which the n first conductive vias and the n second conductive vias belong, n third conductive vias in the third via region (23) and n fourth conductive vias in the fourth via region (24) are symmetrical about the first axis of the channel signal region (11, 12, 13, 14) to which the n third conductive vias and the n fourth conductive vias belong, and the n first conductive vias in the first via region (21) and the n fourth conductive vias in the fourth via region (24) are symmetrical about the second axis of the channel signal region (11, 12, 13, 14) to which the n first conductive vias and the n fourth conductive vias belong;
n second conductive vias in the first via region (21) and n first conductive vias in the second via region (22) are symmetrical about the first axis of the channel signal region (11, 12, 13, 14) to which the n second conductive vias and the n first conductive vias belong, n fourth conductive vias in the third via region (23) and n third conductive vias in the fourth via region (24) are symmetrical about the first axis of the channel signal region (11, 12, 13, 14) to which the n fourth conductive vias and the n third conductive vias belong, and the n second conductive vias in the first via region (21) and the n third conductive vias in the fourth via region (24) are symmetrical about the second axis of the channel signal region (11, 12, 13, 14) to which the n second conductive vias and the n third conductive vias belong;
n third conductive vias in the first via region (21) and n fourth conductive vias in the second via region (22) are symmetrical about the first axis of the channel signal region (11, 12, 13, 14) to which the n third conductive vias and the n fourth conductive vias belong, n first conductive vias in the third via region (23) and n second conductive vias in the fourth via region (24) are symmetrical about the first axis of the channel signal region (11, 12, 13, 14) to which the n first conductive vias and the n second conductive vias belong, and the n third conductive vias in the first via region (21) and the n second conductive vias in the fourth via region (24) are symmetrical about the second axis of the channel signal region (11, 12, 13, 14) to which the n third conductive vias and the n second conductive vias belong; and
n fourth conductive vias in the first via region (21) and n third conductive vias in the second via region (22) are symmetrical about the first axis of the channel signal region (11, 12, 13, 14) to which the n fourth conductive vias and the n third conductive vias belong, n second conductive vias in the third via region (23) and n first conductive vias in the fourth via region (24) are symmetrical about the first axis of the channel signal region (11, 12, 13, 14) to which the n second conductive vias and the n first conductive vias belong, and the n fourth conductive vias in the first via region (21) and the n first conductive vias in the fourth via region (24) are symmetrical about the second axis of the channel signal region (11, 12, 13, 14) to which the n fourth conductive vias and the n first conductive vias belong.

3. The memory chip (10) according to claim 2, wherein the memory chip (10) further comprises (4×m×n) first driver circuits (30), the (4×m×n) first driver circuits (30) are coupled to (4×m×n) first conductive vias in a one-to-one correspondence, and the first driver circuits (30) are coupled to parts that are of the first conductive vias and that are located on the active surface; and
the first driver circuits (30) are configured to send signals transmitted by the correspondingly connected first conductive vias to an internal circuit of the memory chip (10), or send signals generated by an internal circuit of the memory chip (10) to the correspondingly connected first conductive vias.

4. The memory chip (10) according to any one of claims 1 to 3, wherein
a coordinate position of each conductive via is determined based on a center of a channel signal region to which the conductive via belongs, and types of signals transmitted by four conductive vias with a same coordinate position are the same.

5. The memory chip (10) according to any one of claims 2 to 4, wherein
the conductive vias are manufactured through any one or more of a via-first process (via-first), a via-middle process (via-middle), a via-last process (via-last), and a back side via-last process (back side via-last); and different conductive vias in a same memory chip (10) are electrically isolated.

6. A logic chip (40), wherein the logic chip (40) comprises m channel signal regions (41, 42, 43, 44), the m channel signal regions (41, 42, 43, 44) are sequentially arranged in a first direction, the logic chip (40) has a chip axis extending in a second direction and passing through a center of the logic chip (40), and the m channel signal regions (41, 42, 43, 44) are symmetrical about the chip axis, wherein m is a positive integer;
each of the channel signal regions (41, 42, 43, 44) has a first axis and a second axis, the first axis extends in the first direction or the second direction, and the second axis and the first axis are perpendicular to each other and intersect at a center of the channel signal region (41, 42, 43, 44) to which the first axis and the second axis belong; each of the channel signal regions (41, 42, 43, 44) is divided into 2×2 via regions distributed in an array, a first via region (51) and a second via region (52) are symmetrical along the first axis of the channel signal region (41, 42, 43, 44) to which the first via region and the second via region belong, a third via region (53) and a fourth via region (54) are symmetrical along the first axis of the channel signal region (41, 42, 43, 44) to which the third via region and the fourth via region belong, and the first via region (51) and the fourth via region (54) are symmetrical along the second axis of the channel signal region (41, 42, 43, 44) to which the first via region and the fourth via region belong; the second direction is perpendicular to the first direction;
each of the via regions includes n conductive via groups, the n conductive via groups penetrate through a substrate of the logic chip (40) in a direction perpendicular to an active surface of the logic chip (40), and n is a natural number; areas of the m channel signal regions (41, 42, 43, 44) are the same, and distribution positions of the conductive via groups in the m channel signal regions (41, 42, 43, 44) are the same; and
in a same channel signal region (41, 42, 43, 44), n conductive via groups in the first via region (51) and n conductive via groups in the second via region (52) are symmetrical about the first axis of the channel signal region (41, 42, 43, 44) to which the conductive via groups belong, n conductive via groups in the third via region (53) and n conductive via groups in the fourth via region (54) are symmetrical about the first axis of the channel signal region (41, 42, 43, 44) to which the conductive via groups belong, and the n conductive via groups in the first via region (51) and the n conductive via groups in the fourth via region (54) are symmetrical about the second axis of the channel signal region (41, 42, 43, 44) to which the conductive via groups belong.

7. The logic chip (40) according to claim 6, wherein
each of the conductive via groups has a third axis and a fourth axis, the third axis is parallel to the first axis, and the fourth axis and the third axis are perpendicular to each other and intersect at a center of the conductive via group to which the third axis and the fourth axis belong;
when each of the conductive via groups comprises a first conductive via, a second conductive via, a third conductive via, and a fourth conductive via that are distributed in a 2×2 array, the first conductive via and the second conductive via are symmetrical about the third axis of the conductive via group to which the first conductive via and the second conductive via belong, the third conductive via and the fourth conductive via are symmetrical about the third axis of the conductive via group to which the third conductive via and the fourth conductive via belong, and the first conductive via and the fourth conductive via are symmetrical about the fourth axis of the conductive via group to which the first conductive via and the fourth conductive via belong; in each of the channel signal regions (41, 42, 43, 44), n first conductive vias in the first via region (51) and n second conductive vias in the second via region (52) are symmetrical about the first axis of the channel signal region (41, 42, 43, 44) to which the n first conductive vias and the n second conductive vias belong, n third conductive vias in the third via region (53) and n fourth conductive vias in the fourth via region (54) are symmetrical about the first axis of the channel signal region (41, 42, 43, 44) to which the n third conductive vias and the n fourth conductive vias belong, and the n first conductive vias in the first via region (51) and the n fourth conductive vias in the fourth via region (54) are symmetrical about the second axis of the channel signal region (41, 42, 43, 44) to which the n first conductive vias and the n fourth conductive vias belong;
n second conductive vias in the first via region (51) and n first conductive vias in the second via region (52) are symmetrical about the first axis of the channel signal region (41, 42, 43, 44) to which the n second conductive vias and the n first conductive vias belong, n fourth conductive vias in the third via region (53) and n third conductive vias in the fourth via region (54) are symmetrical about the first axis of the channel signal region (41, 42, 43, 44) to which the n fourth conductive vias and the n third conductive vias belong, and the n second conductive vias in the first via region (51) and the n third conductive vias in the fourth via region (54) are symmetrical about the second axis of the channel signal region (41, 42, 43, 44) to which the n second conductive vias and the n third conductive vias belong;
n third conductive vias in the first via region (51) and n fourth conductive vias in the second via region (52) are symmetrical about the first axis of the channel signal region (41, 42, 43, 44) to which the n third conductive vias and the n fourth conductive vias belong, n first conductive vias in the third via region (53) and n second conductive vias in the fourth via region (54) are symmetrical about the first axis of the channel signal region (41, 42, 43, 44) to which the n first conductive vias and the n second conductive vias belong, and the n third conductive vias in the first via region (51) and the n second conductive vias in the fourth via region (54) are symmetrical about the second axis of the channel signal region (41, 42, 43, 44) to which the n third conductive vias and the n second conductive vias belong; and
n fourth conductive vias in the first via region (51) and n third conductive vias in the second via region (52) are symmetrical about the first axis of the channel signal region (41, 42, 43, 44) to which the n fourth conductive vias and the n third conductive vias belong, n second conductive vias in the third via region (53) and n first conductive vias in the fourth via region (54) are symmetrical about the first axis of the channel signal region (41, 42, 43, 44) to which the n second conductive vias and the n first conductive vias belong, and the n fourth conductive vias in the first via region (51) and the n first conductive vias in the fourth via region (54) are symmetrical about the second axis of the channel signal region (41, 42, 43, 44) to which the n fourth conductive vias and the n first conductive vias belong.

8. The logic chip (40) according to claim 7, wherein
the logic chip (40) further comprises (16×m×n) second driver circuits (50), the (16×m×n) second driver circuits (50) are coupled to (16×m×n) conductive vias in a one-to-one correspondence, and the second driver circuits (50) are coupled to parts that are of the conductive vias and that are located on the active surface; and
the second driver circuits (50) are configured to send signals transmitted by the corresponding conductive vias to an internal circuit of the logic chip (40), or send signals generated by an internal circuit of the logic chip (40) to the corresponding conductive vias.

9. The logic chip (40) according to any one of claims 6 to 8, wherein
a coordinate position of each conductive via is determined based on a center of a channel signal region to which the conductive via belongs, and types of signals transmitted by four conductive vias with a same coordinate position are the same; and
the conductive vias are manufactured through any one or more of a via-first process (via-first), a via-middle process (via-middle), a via-last process (via-last), and a back side via-last process (back side via-last), and different conductive vias in a same logic chip (40) are electrically isolated from each other.

10. A chip stacked structure (70), wherein the chip stacked structure (70) comprises the logic chip (40) according to claims 6 to 9 and at least one stacked unit (71), the logic chip (40) and the at least one stacked unit (71) are sequentially stacked in a third direction, each stacked unit (71) comprises a first memory chip (10A), a second memory chip (10B), a third memory chip (10C), and a fourth memory chip (10D) that are sequentially stacked in the third direction, the third direction is perpendicular to an active surface of each of the memory chips, and the first memory chip (10A), the second memory chip (10B), the third memory chip (10C), and the fourth memory chip (10D) each are the memory chip (10) according to any one of claims 1 to 5;
the logic chip (40) and the first memory chip (10A) are stacked in a face-to-back or back-to-back manner;
the first memory chip (10A) and the second memory chip (10B) are stacked in a face-to-face manner;
the second memory chip (10B) and the third memory chip (10C) are stacked in a back-to-back manner; and
the third memory chip (10C) and the fourth memory chip (10D) are stacked in a face-to-face manner.

11. The chip stacked structure (70) according to claim 10, wherein the logic chip (40) comprises m channel signal regions arranged in a first direction, each of the memory chips (10A, 10B, 10C, 10D) has m channels arranged in the first direction, and each of the channels comprises a first memory array region, a channel signal region, and a second memory array region that are sequentially distributed in a second direction; and
when the logic chip (40) and the first memory chip (10A) are stacked in a back-to-back manner, and a first axis of the logic chip (40) and a first axis of each of the memory chips (10A, 10B, 10C, 10D) extend in the first direction,
an (m-i)th channel signal region in the logic chip (40) is aligned with the channel signal region in an (i+1)th channel in the first memory chip (10A), the channel signal region in an (i+1)th channel in the second memory chip (10B), the channel signal region in an (m-i)th channel in the third memory chip (10C), and the channel signal region in an (m-i)th channel in the fourth memory chip (10D) in the third direction, wherein i is a natural number less than m.

12. The chip stacked structure (70) according to claim 10, wherein the logic chip (40) comprises m channel signal regions arranged in a first direction, each of the memory chips (10A, 10B, 10C, 10D) has m channels arranged in the first direction, and each of the channels comprises a first memory array region, a channel signal region, and a second memory array region that are sequentially distributed in a second direction; and
when the logic chip (40) and the first memory chip (10A) are stacked in a back-to-back manner, and a second axis of the logic chip (40) and a second axis of each of the memory chips (10A, 10B, 10C, 10D) extend in the first direction,
an (i+1)th channel signal region in the logic chip (40) is aligned with the channel signal region in an (i+1)th channel in the first memory chip (10A), the channel signal region in an (m-i)th channel in the second memory chip (10B), the channel signal region in an (m-i)th channel in the third memory chip (10C), and the channel signal region in an (i+1)th channel in the fourth memory chip (10D) in the third direction, wherein i is a natural number less than m.

13. The chip stacked structure (70) according to claim 11 or 12, wherein the channel signal region in each of the channels is divided into 2×2 via regions distributed in an array; and
only for a plurality of channel signal regions aligned in the third direction:
a fourth via region belonging to the logic chip (40), a first via region belonging to the first memory chip (10A), a second via region belonging to the second memory chip (10B), a third via region belonging to the third memory chip (10C), and a fourth via region belonging to the fourth memory chip (10D) are aligned in the third direction;
a third via region belonging to the logic chip (40), a second via region belonging to the first memory chip (10A), a first via region belonging to the second memory chip (10B), a fourth via region belonging to the third memory chip (10C), and a third via region belonging to the fourth memory chip (10D) are aligned in the third direction;
a second via region belonging to the logic chip (40), a third via region belonging to the first memory chip (10A), a fourth via region belonging to the second memory chip (10B), a first via region belonging to the third memory chip (10C), and a second via region belonging to the fourth memory chip (10D) are aligned in the third direction; and
a first via region belonging to the logic chip (40), a fourth via region belonging to the first memory chip (10A), a third via region belonging to the second memory chip (10B), a second via region belonging to the third memory chip (10C), and a first via region belonging to the fourth memory chip (10D) are aligned in the third direction.

14. The chip stacked structure (70) according to claim 13, wherein each of the via regions comprises n conductive via groups with a same distribution position, each conductive via group has a third axis and a fourth axis, the third axis is parallel to the first axis, and the fourth axis and the third axis are perpendicular to each other and intersect at a center of the conductive via group to which the fourth axis and the third axis belong; when each of the conductive via groups comprises a first conductive via, a second conductive via, a third conductive via, and a fourth conductive via that are distributed in a 2×2 array, the first conductive via and the second conductive via are symmetrical about the third axis of the conductive via group to which the first conductive via and the second conductive via belong, the third conductive via and the fourth conductive via are symmetrical about the third axis of the conductive via group to which the third conductive via and the fourth conductive via belong, and the first conductive via and the fourth conductive via are symmetrical about the fourth axis of the conductive via group to which the first conductive via and the fourth conductive via belong; and
only for a plurality of via regions aligned in the third direction:
the fourth conductive via belonging to the logic chip (40), the first conductive via belonging to the first memory chip (10A), the second conductive via belonging to the second memory chip (10B), the third conductive via belonging to the third memory chip (10C), and the fourth conductive via belonging to the fourth memory chip (10D) are aligned in the third direction;
the third conductive via belonging to the logic chip (40), the second conductive via belonging to the first memory chip (10A), the first conductive via belonging to the second memory chip (10B), the fourth conductive via belonging to the third memory chip (10C), and the third conductive via belonging to the fourth memory chip (10D) are aligned in the third direction;
the second conductive via belonging to the logic chip (40), the third conductive via belonging to the first memory chip (10A), the fourth conductive via belonging to the second memory chip (10B), the first conductive via belonging to the third memory chip (10C), and the second conductive via belonging to the fourth memory chip (10D) are aligned in the third direction; and
the first conductive via belonging to the logic chip (40), the fourth conductive via belonging to the first memory chip (10A), the third conductive via belonging to the second memory chip (10B), the second conductive via belonging to the third memory chip (10C), and the first conductive via belonging to the fourth memory chip (10D) are aligned in the third direction;
wherein a plurality of conductive vias aligned in the third direction are coupled to form a conductive channel.

15. The chip stacked structure (70) according to claim 10, wherein the logic chip (40) comprises m channel signal regions arranged in a first direction, each of the memory chips has m channels arranged in the first direction, and each channel comprises a first memory array region, a channel signal region, and a second memory array region that are sequentially distributed in a second direction; and
when the logic chip (40) and the first memory chip (10A) are stacked in a back-to-back manner, and a first axis of the logic chip (40) and a first axis of each of the memory chips extend in the first direction,
an (i+1)th channel signal region in the logic chip (40) is aligned with the channel signal region in an (i+1)th channel in the first memory chip (10A), the channel signal region in an (i+1)th channel in the second memory chip (10B), the channel signal region in an (m-i)th channel in the third memory chip (10C), and the channel signal region in an (m-i)th channel in the fourth memory chip (10D) in the third direction, wherein i is a natural number less than m.

16. The chip stacked structure (70) according to claim 15, wherein the logic chip (40) comprises m channel signal regions arranged in the first direction, each of the memory chips has m channels arranged in the first direction, and each channel comprises a first memory array region, a channel signal region, and a second memory array region that are sequentially distributed in the second direction; and
when the logic chip (40) and the first memory chip (10A) are stacked in a back-to-back manner, and a second axis of the logic chip (40) and a second axis of each of the memory chips extend in the first direction,
an (m-i)th channel signal region in the logic chip (40) is aligned with the channel signal region in the (i+1)th channel in the first memory chip (10A), the channel signal region in an (m-i)th channel in the second memory chip (10B), the channel signal region in the (m-i)th channel in the third memory chip (10C), and the channel signal region in an (i+1)th channel in the fourth memory chip (10D) in the third direction, wherein i is a natural number less than m.

17. The chip stacked structure (70) according to claim 15 or 16, wherein
only for a plurality of channel signal regions aligned in the third direction:
a second via region belonging to the logic chip (40), a first via region belonging to the first memory chip (10A), a second via region belonging to the second memory chip (10B), a third via region belonging to the third memory chip (10C), and a fourth via region belonging to the fourth memory chip (10D) are aligned in the third direction;
a first via region belonging to the logic chip (40), a second via region belonging to the first memory chip (10A), a first via region belonging to the second memory chip (10B), a fourth via region belonging to the third memory chip (10C), and a third via region belonging to the fourth memory chip (10D) are aligned in the third direction;
a fourth via region belonging to the logic chip (40), a third via region belonging to the first memory chip (10A), a fourth via region belonging to the second memory chip (10B), a first via region belonging to the third memory chip (10C), and a second via region belonging to the fourth memory chip (10D) are aligned in the third direction; and
a third via region belonging to the logic chip (40), a fourth via region belonging to the first memory chip (10A), a third via region belonging to the second memory chip (10B), a second via region belonging to the third memory chip (10C), and a first via region belonging to the fourth memory chip (10D) are aligned in the third direction.

18. The chip stacked structure (70) according to claim 17, wherein each of the via regions comprises n conductive via groups with a same distribution position, each of the conductive via groups has a third axis and a fourth axis, the third axis is parallel to the first axis, and the fourth axis and the third axis are perpendicular to each other and intersect at a center of the conductive via group to which the third axis and the fourth axis belong;
when each of the conductive via groups comprises a first conductive via, a second conductive via, a third conductive via, and a fourth conductive via that are distributed in a 2×2 array, the first conductive via and the second conductive via are symmetrical about the third axis of the conductive via group to which the first conductive via and the second conductive via belong, the third conductive via and the fourth conductive via are symmetrical about the third axis of the conductive via group to which the third conductive via and the fourth conductive via belong, and the first conductive via and the fourth conductive via are symmetrical about the fourth axis of the conductive via group to which the first conductive via and the fourth conductive via belong; and
for a plurality of via regions aligned in the third direction:
the second conductive via belonging to the logic chip (40), the first conductive via belonging to the first memory chip (10A), the second conductive via belonging to the second memory chip (10B), the third conductive via belonging to the third memory chip (10C), and the fourth conductive via belonging to the fourth memory chip (10D) are aligned in the third direction;
the first conductive via belonging to the logic chip (40), the second conductive via belonging to the first memory chip (10A), the first conductive via belonging to the second memory chip (10B), the fourth conductive via belonging to the third memory chip (10C), and the third conductive via belonging to the fourth memory chip (10D) are aligned in the third direction;
the fourth conductive via belonging to the logic chip (40), the third conductive via belonging to the first memory chip (10A), the fourth conductive via belonging to the second memory chip (10B), the first conductive via belonging to the third memory chip (10C), and the second conductive via belonging to the fourth memory chip (10D) are aligned in the third direction; and
the third conductive via belonging to the logic chip (40), the fourth conductive via belonging to the first memory chip (10A), the third conductive via belonging to the second memory chip (10B), the second conductive via belonging to the third memory chip (10C), and the first conductive via belonging to the fourth memory chip (10D) are aligned in the third direction;
wherein a plurality of conductive vias aligned in the third direction are coupled to form a conductive channel.

19. The chip stacked structure (70) according to any one of claims 10 to 18, wherein
for two chips connected in a face-to-face manner, positions at which conductive vias in the two chips are aligned in the third direction are electrically connected through a hybrid bonding process; for two chips connected in a back-to-back manner or for two chips connected in a face-to-back manner, positions at which conductive vias in the two chips are aligned in the third direction are electrically connected through a conductive bump bonding process; or
for two chips connected in a face-to-face manner, for two chips connected in a back-to-back manner, or for two chips connected in a face-to-back manner, positions aligned with conductive vias in the two chips in the third direction are electrically connected through a hybrid bonding process; or
for two chips connected in a face-to-face manner, for two chips connected in a back-to-back manner, or for two chips connected in a face-to-back manner, positions aligned with conductive vias in the two chips in the third direction are electrically connected through a conductive bump bonding process.

20. A memory (80), comprising the chip stacked structure (70) according to any one of claims 10 to 19.
